(19) Europäisches Patentamt
European Patent Office
Office européen des brevets

(11) **EP 2 948 988 B1**

(12) **FASCICULE DE BREVET EUROPEEN**

(45) Date de publication et mention de la délivrance du brevet:
**08.04.2020 Bulletin 2020/15**

(21) Numéro de dépôt: **14701507.7**

(22) Date de dépôt: **21.01.2014**

(51) Int Cl.:
*H01L 33/14* (2010.01)     *H01L 33/24* (2010.01)

(86) Numéro de dépôt international:
**PCT/EP2014/051067**

(87) Numéro de publication internationale:
**WO 2014/114606 (31.07.2014 Gazette 2014/31)**

(54) **STRUCTURE SEMICONDUCTRICE ET PROCEDE DE FABRICATION D'UNE STRUCTURE SEMICONDUCTRICE**

HALBLEITERSTRUKTUR UND VERFAHREN ZUR HERSTELLUNG EINER HALBLEITERSTRUKTUR

SEMICONDUCTOR STRUCTURE AND METHOD FOR MANUFACTURING A SEMICONDUCTOR STRUCTURE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **22.01.2013 FR 1350540**
**12.06.2013 FR 1355438**

(43) Date de publication de la demande:
**02.12.2015 Bulletin 2015/49**

(73) Titulaire: **Commissariat à l'Énergie Atomique et aux Énergies Alternatives**
**75015 Paris (FR)**

(72) Inventeur: **VAUFREY, David**
**F-38000 Grenoble (FR)**

(74) Mandataire: **Brevalex**
**95, rue d'Amsterdam**
**75378 Paris Cedex 8 (FR)**

(56) Documents cités:
EP-A2- 2 375 458     US-A1- 2002 104 997
US-A1- 2011 244 616     US-A1- 2013 221 385

- **KOLPER C ET AL: "Core-shell InGaN nanorod light emitting diodes: Electronic and optical device properties", PHYSICA STATUS SOLIDI (A) APPLICATIONS AND MATERIALS SCIENCE NOVEMBER 2012 WILEY-VCH VERLAG DEU, vol. 209, no. 11, novembre 2012 (2012-11), pages 2304-2312, XP002722041, DOI: 10.1002/PSSA.201228178**

# Description

## DOMAINE TECHNIQUE

L'invention se rapporte au domaine de l'émission de lumière et des dispositifs adaptés pour une telle émission de lumière.

On note ces vingt dernières années une tendance lourde vers la minimisation de la consommation énergétique des appareils électriques. Les dispositifs adaptés pour émettre de la lumière ne sont pas épargnés par une telle tendance.

Ainsi, les sources de lumière de ces dispositifs sont passées tour à tour des sources de lumière incandescentes, aux tubes fluorescents et, ces dernières années, aux structures semiconductrices.

Bien que le gain en consommation d'une telle structure vis-à-vis d'un tube fluorescent soit significatif, l'optimisation du rendement énergétique reste une problématique d'actualité.

L'invention concerne plus particulièrement une structure semiconductrice et le procédé de fabrication d'une telle structure.

## ÉTAT DE LA TECHNIQUE ANTÉRIEURE

Les structures semiconductrices adaptées pour émettre de la lumière sont généralement des structures de type diode électroluminescente, plus connues sous leur sigle français DEL ou anglais LED. Une structure de ce type comporte une première et une deuxième zone semiconductrice présentant respectivement un premier et un deuxième type de conductivité opposés l'un à l'autre, la première et la deuxième zone étant reliées l'une à l'autre de manière à former une jonction semiconductrice.

Selon une configuration usuelle qui est celle d'une diode verticale (plus connue sous la dénomination anglaise « Vertical Thin Film Diode » et sous le sigle anglais VTF LED), une telle structure présente une première face selon laquelle la lumière est émise, la deuxième face, opposée à la première, présentant une couche réfléchissante adaptée pour réfléchir la partie de la lumière qui n'est pas émise en direction de la face émettrice. Dans une telle configuration, la première zone comporte la première face et la deuxième zone comporte la deuxième face.

Afin de permettre une polarisation de la structure, chacune des zones comporte un contact électrique, le contact électrique de la deuxième zone formant la couche réfléchissante. Dans cette même configuration, le contact électrique de la première zone, afin de laisser passer la lumière émise par la jonction, occupe une surface réduite de la première face.

Ainsi, les contacts électriques permettent de polariser la jonction dans laquelle a lieu la génération des photons.

Une telle structure, si elle permet une émission de lumière avec un fort rendement énergétique vis-à-vis des sources de lumière à tube fluorescent, présente un certain nombre d'inconvénients. En effet, de par sa conception et la faible conductivité des matériaux dans lesquels sont formées la première et la deuxième zone semiconductrice (en comparaison de la conductivité des contacts électriques) le courant, et donc les porteurs, circule principalement dans un volume des première et seconde zones semiconductrices défini par les lignes de projection orthogonale du contact de la première zone sur le contact de la deuxième zone, ce volume étant appelé volume de conduction. L'émission de lumière a donc principalement lieu dans la partie de la jonction comprise dans ce volume de conduction.

En somme, la dispersion du courant dans la jonction de la diode électroluminescente est faible puisque la densité de courant est maximale dans le volume de conduction et décroît rapidement dans les parties de la jonction adjacentes audit volume.

Il en résulte deux inconvénients qui sont qu'une majeure partie de la jonction ne contribue pas à l'émission de la lumière, puisqu'elle n'est pas traversée par un courant, et que l'émission ayant principalement lieu entre les deux contacts électriques, une part importante de la lumière émise est piégée dans une cavité optique formée par les deux contacts électriques non transparents.

Il est connu, afin de remédier à ces inconvénients, de prévoir dans la première zone un système de blocage de porteurs s'étendant uniquement en regard du contact électrique de la première zone. Un tel système de blocage, formé par insertion d'une zone semiconductrice de plus grand gap que le gap du semi-conducteur formant la première zone, permet de créer une barrière énergétique. Cette barrière énergétique impose aux porteurs électriques de la contourner afin d'atteindre la jonction. Autrement dit, les porteurs sont déviés vers les parties de la jonction non comprises dans le volume de conduction décrit précédemment.

Ainsi, avec une telle déviation du courant de porteurs à la périphérie de la région formant le système de blocage, l'émission de lumière a lieu dans la jonction sur une partie plus étendue que celle contenue dans le volume de conduction. Il en résulte donc une augmentation du rendement d'émission de la jonction et donc de la structure, la surface d'émission étant plus grande et la part du rayonnement piégé par les contacts électriques étant réduite.

Néanmoins, l'aménagement d'un tel système de blocage lors de la fabrication d'une structure semiconductrice nécessite un nombre important d'étapes de fabrication supplémentaires qui entraîne, par rapport à une structure ne présentant pas un tel système de blocage, un surcoût de fabrication non négligeable peu compatible avec les applications grand public. En particulier, l'étape de structuration du système de blocage afin que celui-ci ne s'étende que sur les parties de la première zone en regard du premier contact électrique, requiert une sortie puis un retour dans le bâti de croissance des zones semiconductrices.

De plus, un tel système de blocage est principalement optimisé pour les faibles tensions de polarisation de la structure. En effet, pour les tensions de polarisation supérieures à la hauteur de barrière induite par le système de blocage, le courant n'est plus totalement dévié et une partie non négligeable de lumière est émise dans la région entre les deux contacts électriques. Une structure présentant un tel système n'est donc pas optimisée pour les applications nécessitant une forte émission de lumière.

Il est également connu, pour remédier aux inconvénients présentés par une structure sans système de blocage, d'insérer une électrode transparente entre le contact électrique de la première zone et la première zone. Une telle électrode transparente, généralement réalisée en oxyde d'indium-étain (ITO), s'étend le long de la face émettrice.

Ainsi, avec une telle électrode, la polarisation est appliquée sur l'ensemble de la structure et le courant de porteurs se distribue uniformément dans la structure. Il en résulte que l'émission de lumière a lieu sur la majeure partie de la jonction et que seule une faible part du rayonnement lumineux est piégée entre les contacts électriques des première et seconde zones, le reste du rayonnement passant au travers de l'électrode transparente.

Si une structure comportant une telle électrode transparente permet une émission de lumière sur toute la surface de la jonction, elle présente néanmoins l'inconvénient qu'une telle électrode, en plus d'absorber une partie de la lumière émise, présente une conductivité réduite vis-à-vis de celle du contact métallique. Une telle réduction de conductivité engendre des pertes électriques qui limitent donc, avec l'absorption de lumière par l'électrode, le rendement énergétique d'une telle structure. De plus, l'emploi d'une telle électrode nécessite des traitements de surface lourds afin d'obtenir un contact électrique ohmique avec le matériau semiconducteur formant la première zone, qui augmentent drastiquement les coûts de fabrication d'une structure présentant une telle électrode vis-à-vis d'une structure ne présentant pas une telle électrode.

Il est également connu pour remédier aux inconvénients présentés ci-avant de considérablement accroître l'épaisseur de la première zone semi-conductrice.

En effet, l'accroissement de l'épaisseur de la première zone autorise un courant circulant dans la diode électroluminescente à se disperser.

Cette solution technologique, bien que très facile à mettre en œuvre, présente le désavantage notable, d'une part, d'accroître le temps de formation de la diode électroluminescente et, d'autre part, de consommer plus de matériaux semiconducteurs. Or, nombre de ces matériaux semiconducteurs sont en quantité limitée sur terre et donc onéreux. C'est le cas en particulier du gallium.

On notera qu'il est également connu du document US 2002/0104997 A1 d'utiliser une couche barrière intermédiaire pour faire barrière à l'injection de courant et couche de dispersion de courant pour augmenter la surface d'émission d'une structure semiconductrice émettrice.

## EXPOSÉ DE L'INVENTION

La présente invention vise à remédier à ces inconvénients.

Un but de l'invention est de fournir une structure semiconductrice adaptée pour émettre de la lumière, présentant un rendement énergétique optimisé vis-à-vis de l'art antérieur et qui puisse être obtenue sans surcoût de fabrication significatif lié aux moyens permettant une telle optimisation du rendement.

A cet effet l'invention concerne une structure semiconductrice comprenant une couche de dispersion selon la revendication 1.

Une telle couche de dispersion permet, lors de la polarisation de la structure la comportant, de disperser les porteurs dans les directions comprises dans le plan de la couche de dispersion. Ainsi, on obtient dans la deuxième partie de la première zone une distribution du courant plus homogène dans la jonction. Les recombinaisons paires électron-trou, et donc l'émission de lumière, dans la jonction peuvent donc avoir lieu sur la majeure partie de la jonction. Il en résulte donc que par rapport à une structure de l'art antérieur ne comportant une telle couche de dispersion l'émission de lumière est répartie sur la majeure partie de la jonction et seule une faible part du rayonnement est absorbée par le contact de la première zone.

De plus une telle couche de dispersion peut, dans une configuration multicouche, être simplement réalisée en modifiant temporairement, durant l'étape de formation de la première zone, les matériaux formant la première zone. Il en résulte que les surcoûts de fabrication d'une structure comportant une telle couche de dispersion peuvent ne pas être significatifs vis-à-vis des coûts de fabrication d'une structure ne comportant pas une telle couche de dispersion.

On entend par dispersion de porteurs, plus connu sous son équivalent anglais de « carrier spreading », la redistribution homogène des porteurs selon le plan de la couche de dispersion.

On entend ci-dessus, et dans le reste de ce document, par « plan de jonction », le plan selon lequel s'étend la surface de contact entre deux zones semiconductrices de conductivité opposée, ledit plan de jonction pouvant par exemple être plan, courbe et/ou présenter une ou plusieurs portions angulaires. Dans le cas où deux zones semiconductrices sont reliées l'une à l'autre par une troisième zone semiconductrice de type intrinsèque ou non intentionnellement dopé, on entend par « plan de jonction » le plan selon lequel s'étend la zone de charge d'espace.

La première et la deuxième zone peuvent être reliées l'une à l'autre par une troisième zone.

La troisième zone peut comprendre un semiconducteur intrinsèque ou non intentionnellement dopé, de nature identique ou différente de celle des première et seconde zones. La troisième zone peut être formée de différentes parties.

La première et la deuxième zone peuvent être en contact physique l'une avec l'autre de manière à former la jonction et à être reliées directement l'une à l'autre.

La couche de dispersion peut s'étendre le long de la totalité de la jonction.

Ainsi les porteurs peuvent être répartis sur la totalité de la jonction.

La couche de dispersion peut présenter sur toute son épaisseur une résistivité plus forte que celle de la première partie de la première zone.

Ainsi la résistivité de la couche de dispersion devient prépondérante par rapport à celle de la première partie et avantageusement par rapport à celle de la deuxième partie. La résistance dans le plan de la première partie est donc négligeable vis-à-vis de la résistance pour traverser orthogonalement la couche de dispersion et n'augmente donc pas significativement la résistance perçue par un porteur s'éloignant du chemin le plus court entre les deux contacts électriques. Il en résulte donc une bonne dispersion des porteurs de la première zone dans les directions comprises dans le plan de la couche de dispersion.

La couche de dispersion peut être constituée d'un seul matériau semiconducteur.

Pour le dire autrement la couche de dispersion peut être réalisée en un même matériau. Par même matériau, on entend que la proportion relative des éléments composant le matériau est constante suivant l'épaisseur de la couche et le long du plan de jonction.

Avec une telle couche de dispersion, la dispersion des porteurs de la première zone est accrue sans que la pureté cristalline de la couche de dispersion ne soit dégradée.

Dans cette possibilité, la couche de dispersion étant constituée d'un seul matériau, elle forme une couche continue.

La couche de dispersion peut comporter une concentration en porteur homogène sur tout son volume.

La couche de dispersion présente ainsi une concentration en porteurs majoritaires homogène le long de la jonction et ne présente pas de chemin de conduction privilégié ce qui lui permet de présenter en fonctionnement une répartition des lignes de courant homogène.

Avantageusement, le matériau de la couche de dispersion est identique à celle du matériau composant les première et seconde parties de la première zone.

Ainsi la première et la deuxième partie de la première zone et la couche de dispersion peuvent être réalisées dans le même matériau.

On entend ci-dessus par le fait que la première et la deuxième partie de la première zone et la couche de dispersion sont réalisées en un même matériau que ces deux parties et la couche de dispersion sont constituées majoritairement des mêmes éléments avec la même proportion relative, la proportion en éléments dopants, c'est-à-dire fournissant des porteurs majoritaires et/ou minoritaires, pouvant être différentes entre cette couche de dispersion et ces deux parties de la première zone. Ainsi la première et la deuxième partie de la première zone et la couche de dispersion peuvent présenter une résistivité différente tout en comportant une même largeur de bande interdite.

De cette manière, la dispersion des porteurs de la première zone est accrue sans création de défauts structuraux induits par la différence de paramètre de maille qu'engendrerait une hétérojonction.

La première partie peut être une couche sensiblement parallèle au plan de jonction, la première partie de la première zone présentant une résistivité $\rho_1$ et une épaisseur $d_1$, la couche de dispersion présentant une résistivité $\rho_d$ et une épaisseur $d_d$ et la jonction présentant dans plan jonction une dimension maximale $2L$, les épaisseurs et les résistivités respectives de la première partie de la première zone et de la couche de dispersion respectant l'inégalité suivante :

$$\frac{\rho_1}{\rho_d} < 100\frac{d_1 \times d_d}{L^2}.$$

Une telle inégalité permet d'assurer que la dispersion des porteurs a bien lieu sur toute la largeur de la jonction, et notamment sur une distance correspondant à la moitié de la dimension maximale $L$ de la jonction.

La couche de dispersion peut présenter sur toute son épaisseur une résistivité plus forte que celle de la première et de la deuxième partie de la première zone.

Selon cette même possibilité et une température de fonctionnement nominale de la structure qui est $T_{nf}$, la couche de dispersion peut présenter

- une bande de conduction de niveau d'énergie inférieure au plus de $kT_{nf}$ au niveau énergétique de la bande de conduction de la première partie de la première zone si la première zone est du type de conductivité pour lequel les porteurs majoritaires sont des électrons, ou
- une bande de valence de niveau d'énergie supérieure au plus de $kT_{nf}$ au niveau d'énergie de la bande de valence de la première partie de la première zone si la première zone est du type de conductivité pour lequel les porteurs majoritaires sont des trous.

On entend ci-dessus et dans le reste de ce document par température de fonctionnement nominale $T_{nf}$ de la structure, la température maximale pour laquelle la structure a été conçue pour fonctionner. Ainsi pour des structures destinées à fonctionner à la température ambiante, la température de fonctionnement nominale $T_{nf}$ sera généralement fixée à 100°C. La couche de dispersion peut être adaptée pour former avec la première partie de la première zone une chute de potentiel pour les porteurs majoritaires de la première zone lorsque ces derniers passent de la première partie de la première zone à la couche de dispersion.

On entend ci-dessus et dans le reste de ce document par porteurs majoritaires de la première ou de la deuxième zone, les porteurs majoritaires correspondant au type de conductivité de la zone correspondante en l'absence de polarisation de la structure. Ainsi par exemple, si la première zone présente une conductivité dans laquelle les porteurs majoritaires sont obtenus au moyen de donneurs d'électrons, les porteurs majoritaires de la première zone sont des électrons. A l'inverse, si la première zone présente une conductivité dans laquelle les porteurs majoritaires sont obtenus au moyen d'accepteurs d'électrons, les porteurs majoritaires sont des trous.

On entend également dans la suite de ce document par porteurs minoritaires de la première ou de la deuxième zone les porteurs d'un type opposé au type des porteurs majoritaires de la zone correspondante.

Ainsi avec une telle chute de potentiel, les porteurs majoritaires de la première zone, lors de leur passage par l'interface entre la première partie et la couche de dispersion, voient une partie de leur énergie potentielle qui est convertie en énergie cinétique. Cette énergie cinétique entraîne une dispersion des porteurs majoritaires de la première zone qui a notamment lieu dans les directions comprises dans le plan de la couche de dispersion.

La couche de dispersion peut également présenter

- une bande de conduction de niveau d'énergie supérieur au niveau d'énergie de la bande de conduction de la deuxième partie de la première zone d'une valeur au moins égale à $kT_{nf}$ si la première zone est du type de conductivité pour laquelle les porteurs majoritaires sont des électrons, ou
- une bande de valence de niveau d'énergie inférieur au niveau d'énergie de la bande de valence de la deuxième partie de la première zone d'une valeur au moins égale à $kT_{nf}$ si la première zone est du type de conductivité pour laquelle les porteurs majoritaires sont des trous, k étant dans l'expression ci-dessus la constante de Boltzmann.

La couche de dispersion peut être adaptée pour former avec la deuxième partie de la première zone une chute de potentiel pour les porteurs majoritaires de la première zone lorsque ces derniers passent de la couche de dispersion à la deuxième partie.

Ainsi avec une telle chute de potentiel, les porteurs majoritaires de la première zone, lors de leur passage par l'interface entre la couche de dispersion et la deuxième partie de la première zone, voient une partie de leur énergie potentielle qui est convertie en énergie cinétique. Cette énergie cinétique entraîne une dispersion des porteurs majoritaires de la première zone qui a notamment lieu dans les directions comprises dans le plan de la couche de dispersion.

La couche de dispersion peut également présenter :

- une bande de conduction de niveau d'énergie inférieur au niveau d'énergie de la bande de conduction d'une valeur au moins égale à $kT_{nf}$ de la seconde partie de la première zone si la première zone est du type de conductivité pour lequel les porteurs majoritaires sont des électrons, ou
- une bande de valence de niveau d'énergie supérieur au niveau d'énergie de la bande de valence de la seconde partie de la première zone d'une valeur au moins égale à $kT_{nf}$ si la première zone est du type de conductivité pour lequel les porteurs majoritaires sont des trous.

Selon cette dernière possibilité, la deuxième partie de la première zone peut présenter une largeur de bande interdite dont l'énergie est inférieure à la largeur de bande interdite de la couche de dispersion.

Une telle différence entre les largeurs de bandes interdites de la deuxième partie et de la couche de dispersion peut permettre de ne pas créer une barrière de potentiel entre la couche de dispersion et la deuxième zone. Ceci permet de limiter les pertes lors du fonctionnement de la structure et donc d'améliorer le rendement énergétique de la structure.

La couche de dispersion peut être adaptée pour former avec la deuxième partie une barrière de potentiel pour les porteurs majoritaires de la première zone lorsque ces derniers passent de la couche de dispersion à la deuxième partie.

Avec une telle barrière de potentiel, la résistance d'interface entre la couche de dispersion et la deuxième partie de la première zone est augmentée pour les porteurs majoritaires de la première zone lorsque ces derniers passent de la couche de dispersion à la deuxième partie de la première zone. Ainsi, la résistance pour les porteurs majoritaires le long de la couche de dispersion est donc négligeable vis-à-vis de la barrière énergétique d'interface entre la couche de dispersion et la deuxième partie de la première zone et n'augmente donc pas significativement la résistance perçue par un porteur s'éloignant du chemin le plus court entre les contacts électriques de la première zone et de la deuxième zone.

La couche de dispersion peut présenter :

- une bande de conduction de niveau d'énergie supérieure au niveau énergétique de la bande de conduction de la seconde partie de la première zone d'une valeur inférieure à $kT_{nf}$ pour une première zone du type de conductivité pour lequel les porteurs majoritaires sont des électrons, ou
- une bande de valence de niveau énergétique inférieure au niveau énergétique de la bande de valence de la seconde zone d'une valeur inférieure à $kT_{nf}$ pour une première zone du type de conductivité pour lequel les porteurs majoritaires sont des trous.

Selon cette dernière possibilité, la deuxième partie de la première zone peut présenter une largeur de bande interdite dont l'énergie est supérieure à celle de la largeur de bande interdite de la couche de dispersion.

La couche de dispersion peut former un puits de potentiel, pour les porteurs majoritaires de la première zone, entre la première et la deuxième partie de la première zone.

Ainsi, les porteurs majoritaires de la première zone traversant l'interface entre la première partie et la couche de dispersion perdent une partie de leur énergie potentielle qui est convertie en énergie cinétique et sont partiellement confinés dans la couche de dispersion en raison de la barrière de potentiel présente à l'interface entre la couche de dispersion et la deuxième partie de la première zone. Les porteurs majoritaires de la première zone sont donc à même, en raison de leur énergie cinétique et du confinement partiel dans la couche de dispersion, de se disperser dans les directions comprises dans le plan de la couche de dispersion.

La première zone peut être formée d'au moins trois éléments chimiques dont la proportion en au moins un desdits éléments permet de varier la largeur de bande interdite d'un matériau semiconducteur formé desdits éléments, la couche de dispersion présentant une proportion moyenne en au moins un des éléments différents de celle d'au moins la première partie de la première zone de manière à ce que la couche de dispersion présente une largeur de bande interdite inférieure à celle de la première partie.

De tels éléments chimiques permettent lors de la fabrication de la structure, en faisant varier la proportion d'au moins un de ces éléments lors de l'étape de fourniture de la première zone, de modifier la largeur de bande interdite en fonction des valeurs de bande interdite recherchée. On obtient ainsi une structure selon l'invention avec des coûts de fabrication du même ordre de grandeur que ceux d'une structure de l'art antérieur.

La première zone peut être formée d'au moins trois éléments chimiques sélectionnés dans le groupe comportant l'indium (In), le gallium (Ga), l'aluminium (Al), l'azote (N) et un élément chimique donneur ou accepteur d'électrons pour les semiconducteurs formés par lesdits éléments chimiques.

La structure peut être une structure du type planaire, c'est-à-dire que le plan de jonction se présente sous une forme sensiblement plane.

Une telle structure présente une surface d'émission s'étendant sur une majeure partie de la surface occupée par la structure.

La structure peut être un fil semiconducteur présentant une configuration du type cœur-coquille, le plan de jonction se présentant sous la forme sensiblement d'une enveloppe séparant un cœur de fil longiligne et une coquille entourant le cœur de fil au moins sur une partie de sa hauteur.

Le plan de jonction peut présenter une forme sensiblement tubulaire ou cylindrique.

Avec une telle configuration du type cœur coquille, la structure présente une surface d'émission particulièrement optimisée par rapport au volume de cette dernière et est donc particulièrement adaptée pour les applications, comme l'éclairage, requérant de fortes émissions de lumière.

La structure peut être un fil semiconducteur présentant une configuration du type cœur-coquille, le plan de jonction se présentant sous la forme sensiblement d'une enveloppe séparant un cœur de fil longiligne et une coquille entourant le cœur de fil au niveau de l'une de ses extrémités et sur une partie de sa hauteur.

La structure peut être un fil semiconducteur présentant une configuration du type cœur-coquille, le plan de jonction se présentant sous la forme sensiblement d'une enveloppe séparant un cœur de fil longiligne et une coquille entourant le cœur de fil uniquement au niveau d'une partie de sa hauteur.

Le cœur de fil peut former la première partie de la première zone et la couche de dispersion, la deuxième partie de la première zone, la troisième zone et la deuxième zone peuvent présenter chacune une forme de coquille dans une configuration du type gigogne.

L'invention concerne également un composant semiconducteur comportant une pluralité de fils semiconducteurs chacun adapté pour émettre un rayonnement électromagnétique, au moins deux fils semiconducteurs sont des fils selon l'invention.

Un tel composant présente, au moins pour les fils qui sont selon l'invention, une émission homogène entre ces derniers.

Les fils semiconducteurs peuvent être connectés en parallèle.

Une telle connexion en parallèle des fils semiconducteurs permet au composant, pour les fils qui sont selon l'invention, de présenter une émission bien répartie entre chacun des fils. En effet, avec une couche de dispersion selon l'invention, les fils semiconducteurs qui sont selon l'invention présentent une impédance relativement homogène par rapport à des fils semiconducteurs classiques dont l'impédance est particulièrement tributaire des fluctuations du procédé de fabrication. Dans un tel composant les fils semiconducteurs présentant donc une impédance homogène, le courant et l'émission de lumière qui en résultent sont répartis de façon homogène entre les fils semiconducteurs.

Les fils semiconducteurs peuvent être connectés indépendamment les uns des autres.

Avec une telle connexion indépendante des fils, les fils semiconducteurs selon l'invention présentent pour une polarisation donnée une émission relativement homogène entre eux puisqu'ils possèdent, du fait de la couche de dispersion, une impédance relativement homogène par rapport à des fils semiconducteurs classiques dont l'impédance est particulièrement tributaire des fluctuations du procédé de fabrication.

L'invention concerne également un procédé de fabrication selon la revendication 12.

Un tel procédé permet la fourniture d'une structure selon l'invention.

Lors de l'étape de formation de la couche de dispersion, la couche de dispersion peut être constituée d'un seul matériau semiconducteur et présentant une résistivité supérieure à celle de la première partie de la première zone.

Lors de l'étape de formation de la deuxième partie de la deuxième partie de la première zone, la deuxième partie de la première zone peut présenter une résistivité inférieure à celle de la couche dispersion.

La première zone peut être une multicouche comportant une première et une deuxième couche formant respectivement la première et la deuxième partie, les étapes de formation de la première et de la deuxième partie étant chacune une étape de formation d'un matériau semiconducteur afin de former une couche dudit matériau.

Les étapes de formation des première et deuxième parties et de la couche de dispersion peuvent être réalisées en une seule étape consistant à déposer un matériau semiconducteur comportant au moins un type d'éléments dopants adapté pour fournir au moins un porteur correspondant au premier type de conductivité, la concentration en l'au moins un type d'éléments dopants étant variée pendant le dépôt de manière à former la couche de dispersion.

Les première et deuxième parties de la première zone et la couche de dispersion peuvent être formées de matériaux semiconducteurs présentant pour au moins la première partie et la couche de dispersion une largeur de bande interdite différente, les étapes de formation des première et deuxième parties et de la couche de dispersion étant réalisées en une seule étape consistant à déposer des éléments chimiques, formant un matériau semiconducteur, dont la composition est variée pendant le dépôt de manière à former successivement la deuxième partie, la couche de dispersion et la première partie.

De tels procédés permettent la fourniture de structures selon l'invention sans surcoûts significatifs vis-à-vis d'une structure selon l'art antérieur, les couches formant la première zone étant fournies en une seule étape.

L'étape de formation de la première partie de la première zone peut être une étape de fourniture d'un cœur de fil, les étapes de formation de la couche de dispersion, de la deuxième partie et de la deuxième zone étant des étapes de formation de couches présentant chacune une forme sensiblement en coquille.

Une telle étape est particulièrement adaptée pour la fourniture d'une structure qui est un fil semiconducteur.

L'invention concerne également un procédé de fabrication d'un composant semiconducteur comportant la mise en œuvre en parrallèle de chacunes des étapes de fabrication d'une structure selon l'invention de manière à former une pluralité de structures.

Un tel procédé permet la fabrication d'un composant dont chacune des structures bénéficie de l'avantage d'une structure selon l'invention et qui présente, de plus une émission des structures l'équipant qui est plus homogène, ces dernières présentant, par le bénéfice de la couche de dispersion, une impédance homogène entre elles par rapport à ce même type de structures ne comportant pas de couche de dispersion.

**BRÈVE DESCRIPTION DES DESSINS**

La présente invention sera mieux comprise à la lecture de la description d'exemples de réalisation, donnés à titre purement indicatif et nullement limitatif, en faisant référence aux dessins annexés sur lesquels :

- la figure 1 illustre une vue schématique en coupe transversale d'une structure selon l'invention,
- la figure 2 illustre un diagramme de bande en bandes plates simplifié et schématisé d'un premier mode de réalisation de l'invention,
- la figure 3 illustre le principe de fonctionnement général d'une structure selon l'invention,
- la figure 4 illustre un diagramme de bandes en bandes plates simplifié et schématisé d'un deuxième mode de réalisation de l'invention,
- la figure 5 illustre un diagramme de bandes en bandes plates simplifié et schématisé d'un troisième mode de réalisation de l'invention,
- la figure 6 illustre un mode de réalisation particulier de l'invention dans lequel la structure selon l'invention est un fil semiconducteur avec une configuration de type cœur-coquille,
- les figures 7a et 7b illustrent respectivement un composant semiconducteur selon l'invention comportant une pluralité de structures illustrées sur la figure 6 et une vue schématique du principe de fonctionnement d'un tel composant.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités et variantes de l'invention doivent être comprises comme n'étant pas exclusives les unes des autres et peuvent se combiner entre elles.

**EXPOSÉ DÉTAILLÉ DE MODES DE RÉALISATION PARTICULIERS**

Les structures selon l'invention décrites ci-dessous sont des exemples de mise en œuvre de l'invention qui ont pour but d'illustrer les possibilités de l'invention et ne sont donc pas limitatives des applications possibles de l'invention. De même les valeurs indiquées ci-dessous, quand cela est précisé, sont des valeurs correspondant à une application particulière de l'invention. Ces valeurs ne doivent donc pas être entendues comme des valeurs limitatives de l'invention et ne sont donc données qu'à titre d'exemple.

Premier mode de réalisation

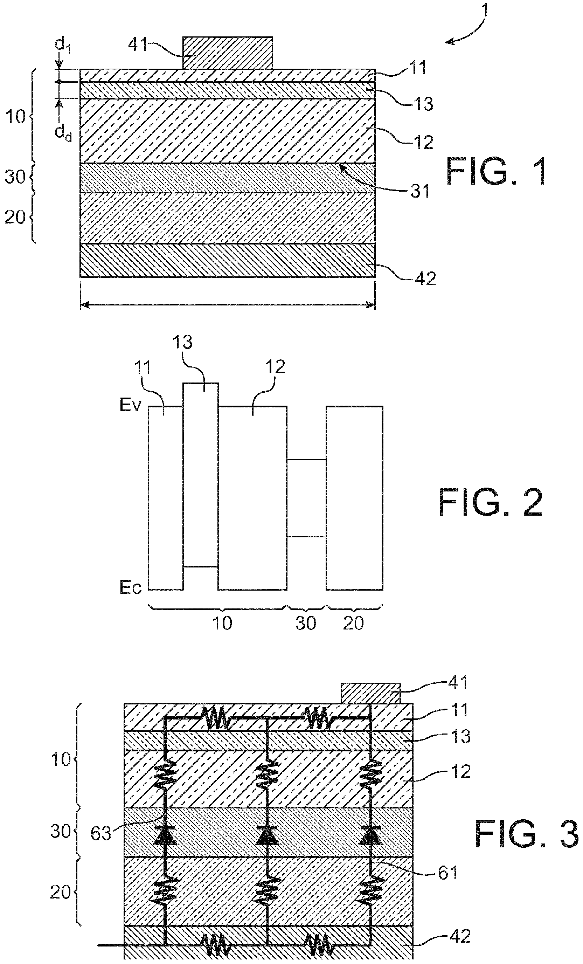

La figure 1 illustre une vue en coupe transversale d'une structure 1 selon un premier mode de réalisation de l'invention qui est une structure adaptée pour émettre un rayonnement électromagnétique, dit plus généralement de la lumière. Ce premier mode de réalisation est le mode de réalisation préféré de l'invention.

La structure 1 selon l'application particulière est une structure adaptée pour émettre un rayonnement électromagnétique dont la gamme de longueurs d'onde est comprise dans la gamme de longueurs d'onde du visible. Bien entendu, l'invention ne se limite pas aux seules gammes de longueurs d'onde présentes dans le visible et le principe de l'invention peut être adaptée sur tout type de structure semiconductrice quelle que soit la gamme de longueur dans laquelle elle est destinée à émettre.

La structure présente une température de fonctionnement nominale à laquelle elle est destinée à fonctionner, une telle température de fonctionnement nominale est notée $T_{nf}$. Dans l'application particulière la température de fonctionnement nominale est égale à 100°C.

Une telle structure 1 comporte une première et une deuxième zone 10, 20 reliées l'une à l'autre par une troisième zone 30 pour former une jonction semiconductrice, chacune étant en contact avec un contact électrique respectif 41, 42.

Plus précisément, une telle structure 1 comporte en partant du deuxième contact 42 électrique en direction du premier contact 41 électrique :

- le deuxième contact 42 électrique,
- la deuxième zone 20 semiconductrice présentant une première et une seconde face, la première face étant en contact avec le deuxième contact 42 électrique, la deuxième zone 20 présentant une conductivité d'un deuxième type,
- la troisième zone 30 semiconductrice en contact avec la deuxième zone 20, sur la seconde face de la deuxième zone 20, la troisième zone 30 présente une largeur de bande interdite inférieure à celle des zones 10 et 20,
- la première zone 10 semiconductrice en contact avec la troisième zone 30, sur la face de la troisième zone 30 qui est opposée à la deuxième zone 20, la première zone 10 présentant une conductivité d'un premier type opposé au deuxième type de conductivité de manière à former avec la deuxième zone 20 une jonction semiconductrice qui s'étend dans la troisième zone 30, la face de la première zone qui est opposée à la troisième zone 30 présentant la surface d'émission de la structure 1,
- le premier contact 41 électrique en contact avec la première zone 10, sur la face de la première zone 10 qui est opposée à la troisième zone 30.

Selon une possibilité avantageuse de l'invention, au moins la première zone 10 et préférentiellement l'ensemble des zones semiconductrices 10, 20, 30 de la structure 1 sont réalisées dans des matériaux semiconducteurs formés d'au moins trois même éléments chimiques adaptés pour que la variation de la proportion d'au moins un de ces éléments chimiques induise une variation de la largeur de bande interdite du matériau comportant ladite proportion dudit élément chimique.

Selon cette possibilité avantageuse de l'invention, les éléments semiconducteurs formés peuvent être une combinaison d'éléments sélectionnés dans les colonnes III et V du tableau périodique de Mendeleiev, tels que l'indium In, le gallium Ga, l'arsenic As, l'antimoine Sb, l'aluminium Al et l'azote N, ou d'éléments sélectionnés dans les colonnes II et VI du tableau périodique de Mendeleiev, tels que le cadmium Cd, le tellure Te, le mercure Hg, le zinc Zn, l'oxygène O et le sélénium Se.

Ainsi dans l'application particulière, les première, deuxième et troisième zones sont composées des trois mêmes éléments chimiques que sont le gallium Ga, l'indium In et l'azote N et sont ainsi formées soit en nitrure de gallium GaN, soit dans un nitrure de gallium-indium $In_xGa_{1-x}N$, x étant une valeur comprise entre 0 et 1.

Dans la configuration illustrée sur la figure 1, la deuxième zone 20 comprend un support semiconducteur sensiblement plat. Le support est un semiconducteur préférentiellement à gap direct. La largeur de bande interdite de la deuxième zone 20 possède une énergie supérieure à celle du rayonnement électromagnétique émis par la structure 1.

Dans l'application particulière, la deuxième zone 20 présente le deuxième type de conductivité qui est un type de conductivité dont les porteurs majoritaires sont des trous. Selon cette même application particulière, la concentration en porteurs majoritaires de la deuxième zone 20 est adaptée pour que ladite deuxième zone 20 présente une résistivité de 1 $\Omega$.cm.

On peut noter que, selon une possibilité alternative de l'invention, qui n'est pas illustrée, la deuxième zone peut comprendre une zone semiconductrice prenant une forme autre que celle d'un support semiconducteur plat.

Selon une configuration alternative de l'invention non illustré, l'invention peut également comporter un support en contact avec la deuxième zone. Dans cette configuration, le support est en contact avec la deuxième couche sur la face de la deuxième zone qui est opposée à la troisième zone. Le deuxième contact électrique forme une couche réfléchissante sur la face du support qui est opposée à la deuxième zone.

La première face de la deuxième zone 20 est en contact avec le deuxième contact électrique 42.

Le deuxième contact 42 électrique est une couche en matériau conducteur adaptée pour injecter des porteurs majoritaires de la deuxième zone 20 dans la deuxième zone 20 et former un contact de type ohmique avec le matériau formant ladite deuxième zone. Le matériau conducteur formant le deuxième contact 42 est préférentiellement un matériau adapté pour réfléchir au moins partiellement, et préférentiellement sensiblement totalement, les rayonnements électromagnétiques dont la longueur d'onde est comprise dans la gamme de longueurs d'onde dans laquelle est destinée à émettre la structure 1.

Le deuxième contact 42 recouvre sensiblement la totalité de la première face de la deuxième zone 20.

La deuxième zone 20 est en contact sur sa deuxième face avec la troisième zone 30.

La troisième zone 30 est une couche semiconductrice réalisée dans un matériau semiconducteur généralement à gap direct dont la largeur de bande interdite est adaptée à la longueur d'onde du rayonnement électromagnétique à laquelle est destinée à émettre la structure 1. Afin d'obtenir un meilleur rendement de la structure, la troisième zone présente préférentiellement, comme cela est illustré sur la figure 2, une largeur de bande interdite qui est inférieure à celle de la première zone et à celle de la deuxième zone.

On peut noter que la troisième zone 30 peut présenter une largeur de bande interdite qui n'est pas inférieure à celle des première et deuxième zones 10, 30.

La troisième zone s'étend selon un plan qui est dit plan de la troisième zone. La troisième zone 30 peut être une zone dite « intrinsèque » ou une zone dite « non intentionnellement dopée ».

On entend par zone non intentionnellement dopée que la concentration en porteurs majoritaires dans ladite zone est celle dans un matériau dans lequel on n'a pas intentionnellement introduit d'éléments dopants, c'est-à-dire adaptés pour fournir des porteurs, et qui présente alors une concentration en porteurs majoritaires qui est dite non intentionnellement dopée. La valeur et le type de porteurs dans une zone du type non intentionnellement dopé sont liés au procédé de formation de ladite zone.

Selon une possibilité de l'invention non illustrée, la troisième zone 30 peut comporter un ou plusieurs systèmes de confinement de porteurs, tel que des puits quantiques afin d'augmenter le rendement d'émission de ladite structure 1.

Dans l'application particulière, la troisième zone 30 est formée en nitrure de gallium-indium $In_xGa_{1-x}N$ avec une proportion en indium In x qui est de 15 %. Selon cette même application, l'épaisseur de la troisième zone 30 est sensiblement égale à 50 nm. La concentration en porteurs dans la troisième zone 30 dans l'application particulière est celle d'un nitrure de gallium-indium $In_xGa_{1-x}N$ de type intrinsèque ou non intentionnellement dopé.

Les valeurs d'épaisseur données ci-dessus et dans le reste de ce document s'entendent comme des valeurs d'épaisseur moyennes, les épaisseurs des zones pouvant présenter des variations locales en fonction des fluctuations de procédés de fabrication et/ou des contraintes structurelles.

La troisième zone 30 est en contact avec la première zone 10 sur la face de la troisième zone 30 qui est opposée à la deuxième zone 20.

Ainsi la troisième zone 30 relie la première et la deuxième zone 10, 20 de manière à former une double hétérojonction semiconductrice. Le plan de la troisième zone 30 forme le plan de jonction.

La première zone 10, selon la possibilité illustrée sur la figure 1, prend la forme d'une multicouche comportant, en partant de la troisième zone en direction du premier contact :

- une deuxième partie 12 prenant la forme d'une couche, la première zone 10 étant reliée à la troisième zone 30 et donc à la deuxième zone 20 par la deuxième partie 12,
- une couche intermédiaire 13, dite de dispersion, qui est en contact avec la deuxième partie 12 sur la face de la deuxième partie 12 qui est opposée à la troisième zone 30,
- une première partie 11 en contact avec la couche de dispersion 13 sur la face de la couche de dispersion 13 qui est opposée à la deuxième partie 12.

La deuxième partie 12 de la première zone 10 est une couche semiconductrice préférentiellement à gap direct. La deuxième partie 12 présente une conductivité du premier type avec une concentration en porteurs majoritaires qui est, en valeur absolue, plus importante que celle de la troisième zone 30. Selon une possibilité de l'invention, la deuxième partie 12 peut être réalisée dans le même matériau semiconducteur que celui de la deuxième zone 20, le type de conductivité étant inversé.

Dans l'application particulière la deuxième partie 12 est réalisée en nitrure de gallium (GaN). Dans cette même application, la concentration en porteurs majoritaires dans la deuxième partie 12 est adaptée pour que la deuxième partie 12 présente une résistivité de $1.10^{-3}$ $\Omega$.cm et la conductivité de cette même deuxième partie 12 est du type de conductivité pour lequel les porteurs majoritaires sont des électrons.

La deuxième partie 12 est en contact avec la couche de dispersion 13.

La couche de dispersion 13 est une couche en matériau semiconducteur préférentiellement à gap direct. La couche de dispersion 13 est du premier type de conductivité. La couche de dispersion 13 présente une résistivité plus forte que celle de la première partie 11, et préférentiellement que celle de la deuxième partie 12. La résistivité augmentée de la couche de dispersion 13 vis-à-vis de la première partie 11 et préférentiellement de la deuxième partie 12, peut être fournie, comme cela est illustré sur la figure 2, par une concentration en porteurs majoritaires dans la couche de dispersion 13 qui est inférieure à celle de la première partie 11 et préférentiellement de la deuxième partie 12. La couche de dispersion 13 est préférentiellement réalisée dans le même matériau que la deuxième partie 12.

Comme le montrent les figures 1 et 2, la couche de dispersion 13 est constituée d'un seul matériau semi-conducteur.

La différence de concentration en porteurs majoritaires entre la première partie 11 et la couche de dispersion 13 implique inévitablement la formation d'une barrière énergétique à l'interface entre cette même première partie 11 et la couche de dispersion 13. Dans le cas particulier de la figure 2, la barrière énergétique correspond à une différence énergétique négative entre les bandes de conduction de la couche de dispersion 13 et la première partie 11. Il est préférable, afin que cette barrière ne limite pas significativement la circulation des porteurs, que les concentrations en porteurs majoritaires de la première partie 11 et la couche de dispersion 13 soient adaptées de manière à ce que la barrière énergétique présente une valeur inférieure à $kT_{nf}$. Autrement dit que les porteurs transitant de la première partie 11 vers la deuxième partie 12 ne ressentent pas la barrière en passant dans la couche de dispersion 13 puisque l'agitation thermique leur permet de la franchir.

La couche de dispersion 13 s'étend sensiblement parallèlement au plan de jonction au moins le long d'une majeure partie de la jonction et préférentiellement, comme cela est illustré sur la figure 1, le long de la totalité de la jonction.

L'épaisseur de la couche de dispersion 13 est adaptée pour permettre une dispersion des porteurs sur toute la longueur de la jonction, la dimension maximale de la structure dans le plan de jonction 31 étant 2L. Une telle adaptation, selon ce mode de réalisation, est obtenue lorsque l'épaisseur de la couche de dispersion respecte l'inégalité suivante :

$$\frac{\rho_1}{\rho_d} < 100 \frac{d_1 \times d_d}{L^2},$$

avec $\rho_1$ et $d_1$ respectivement la résistivité et l'épaisseur de la première partie 11, $\rho_d$ et $d_d$ respectivement la résistivité et l'épaisseur de la couche de dispersion 13.

L'inégalité ci-dessus permet de définir le fait que la résistance à laquelle est soumis un porteur lors de son transit le long de la première partie sur la dimension de dispersion doit être inférieure à la résistance à laquelle est soumis un porteur lors de son passage au travers de la couche de dispersion. Une telle différence permet, comme cela est illustré sur la figure 3, à la structure de présenter une différence de résistance minimale entre le chemin de conduction 61 d'un porteur passant directement du premier contact au deuxième contact et le chemin de conduction 63 d'un porteur transitant tout d'abord le long de la première partie avant de passer au travers des différentes couches 13, 12, 30, 20 formant la structure 1 pour rejoindre le deuxième contact 42. On obtient ainsi une distribution du courant sur toute la majeure partie de la jonction, préférentiellement la totalité de la jonction et donc une émission de lumière répartie sur la majeure partie de la jonction.

Afin d'illustrer l'application pratique de cette inégalité on peut prendre l'exemple présenté ci-dessous.

Ainsi dans une diode électroluminescente présentant une jonction d'un diamètre de 500 $\mu$m (L), dans laquelle doit avoir lieu l'émission de lumière avec un premier contact 41 électrique centrale de diamètre de 50 $\mu$m, une longueur de dispersion, de plus de 225 $\mu$m (L/2) serait nécessaire pour distribuer uniformément le courant sur la « surface de jonction ».

Dans une telle configuration avec une épaisseur de la première zone de 1 $\mu$m et une résistivité de cette dernière de $1.10^{-3}$ $\Omega$.cm, la couche de dispersion pourrait présenter une épaisseur de 0.6 $\mu$m pour une résistivité de 1 $\Omega$.cm ou encore une épaisseur de 60 nm pour une résistivité de 10 $\Omega$.cm.

Dans l'application particulière, la couche de dispersion 13 est réalisée en nitrure de gallium GaN. La couche de dispersion 13 présente un type de conductivité dont les porteurs majoritaires sont des électrons. Dans cette même application particulière, la concentration en porteurs majoritaires est adaptée pour que la couche de dispersion présente une résistivité sensiblement égale à $1.10^{-1}$ $\Omega$.cm.

Ainsi, une telle couche de dispersion 13 est adaptée pour provoquer une dispersion des porteurs de la première zone 10 dans les directions comprises dans le plan de la couche de dispersion 13 et permet d'obtenir une répartition homogène du courant lors de son passage dans la jonction.

La couche de dispersion 13 est en contact avec la première partie 11 de la première zone 10.

La première partie 11 est une couche semiconductrice préférentiellement à gap direct. La première partie 11 est préférentiellement formée dans le même matériau que la deuxième partie 12. La première partie 11 est du premier type de conductivité. La première partie 11 présente une conductivité plus importante que la couche dispersion 13 et du même ordre de grandeur que celle de la deuxième partie 12 et préférentiellement sensiblement égale à celle de la deuxième partie 12.

Ainsi, dans la configuration illustré sur la figure 2, la première et la deuxième partie 11, 12 et la couche de dispersion 13 étant réalisées dans le même matériau semiconducteur, la couche de dispersion 13 forme à son interface avec la première partie 11 une barrière de potentiel pour les porteurs majoritaires de la première zone 10 lorsque ces derniers passent de la première partie 11 à la couche de dispersion 13. Dans cette même configuration, la couche de dispersion 13 forme également à son interface avec la première partie 11 une barrière de potentiel pour les porteurs minoritaires de la première zone 10 lorsque ces derniers passent de la couche de dispersion 13 à la première partie 11.

Dans l'application particulière, la première partie 11 est formée de nitrure de gallium GaN. La première partie 11 est d'un type de conductivité pour lequel les porteurs majoritaires sont des électrons. La première partie 11, dans cette même application particulière, comporte une concentration en porteurs majoritaires adaptée pour que la première partie 11 présente une résistivité de $1.10^{-4}$ $\Omega$.cm.

La première partie 11 est en contact avec le premier contact 41. Le premier contact 41 est un matériau conducteur adapté pour former un contact du type ohmique avec la première partie 11. Le premier contact 41 est en contact avec la première partie 11 sur une portion de la face de la première partie 11 qui est opposée à la couche de dispersion 13. La portion représente un pourcentage au moins inférieur à 20 % de la surface de la face de la première partie 11.

Une telle structure 1 peut être formée par la mise en œuvre d'un procédé de fabrication comprenant les étapes consistant à :

- fournir un support semiconducteur de manière à former la deuxième zone 20, ledit support présentant le deuxième type de conductivité et comportant une première et une seconde face,
- former en contact avec la deuxième face de la deuxième zone 20, une troisième zone 30 semiconductrice, ladite troisième zone 30 étant du type intrinsèque ou du type non intentionnellement dopé,
- former en contact avec la troisième zone 30, sur la face de la troisième zone 30 qui est opposée à première zone 10, la deuxième partie 12, ladite deuxième partie 12 présentant une conductivité du premier type,
- former en contact avec la deuxième partie 12, sur la face de la deuxième partie 12 qui est opposée à la troisième zone 30, la couche de dispersion 13, la couche de dispersion 13 présentant le premier type de conductivité et une résistivité plus importante que celle de la deuxième partie 12,
- former la première partie 11 en contact avec la couche de dispersion 13, sur la face de la couche de dispersion 13 qui est opposée à la deuxième partie 12, la première partie 11 présentant une conductivité du premier type et présentant une concentration en porteurs majoritaires du même ordre de grandeur que celui de la deuxième partie 12, la première partie 11 formant, avec la couche de dispersion 13 et la deuxième partie 12, la première zone 10,
- former le premier contact 41 en contact avec la première partie 11 sur la face de la première partie 11 qui est opposée à la couche de dispersion 13,
- former le deuxième contact électrique 42 en contact avec la première face de la deuxième zone 20.

On peut également noter qu'un tel procédé de fabrication possède l'avantage que la formation des couches 11, 12, 13 composant la première zone 10, dans le cas où l'ensemble des couches constituant la première zone 10 est formé du même matériau, peut être obtenue en une seule étape en modulant la concentration en éléments dopants lors du dépôt dudit matériau pour former la couche de dispersion 13. Ainsi il est possible, de même que pour une diode électroluminescente de l'art antérieur, de former la première zone 10 en une seule étape ceci avec le même équipement mis en œuvre lors de la fabrication de la structure 1 de l'art antérieur.

Bien entendu, l'ordre des étapes du procédé de fabrication décrit ci-dessus n'est pas limitatif et est purement indicatif, et il est envisageable, sans que l'on sorte du cadre de l'invention, que certaines de ces étapes soient réalisées préalablement ou postérieurement à l'ordre décrit ci-dessus. Par exemple, l'étape de formation du premier contact 41 peut être réalisée directement après l'étape de fourniture du support.

## Deuxième mode de réalisation

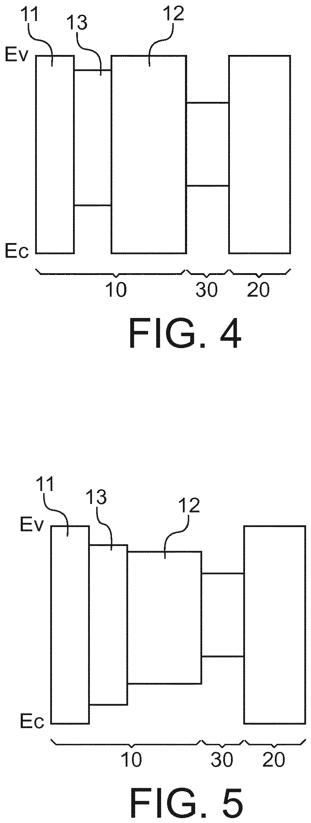

La figure 4 illustre schématiquement un diagramme de bandes de bandes plates d'une structure 1 selon un deuxième mode de réalisation de l'invention. Une structure 1 selon le deuxième mode de réalisation se différencie d'une structure 1 selon le premier mode de réalisation en ce que la couche de dispersion 13 présente une largeur de bande interdite inférieure à celle des première et deuxième parties 11, 12 de la première zone 10.

Dans ce mode de réalisation, la couche de dispersion 13 est réalisée dans un matériau semiconducteur qui présente une largeur de bande interdite inférieure au matériau semiconducteur formant la première et la deuxième partie 11, 12 de la première zone 10.

Dans ce mode de réalisation, comme le montrent la figure 4, La couche de dispersion 13 est constituée d'un seul matériau semiconducteur.

Dans le mode de réalisation illustré en figure 4, la couche de dispersion 13 forme un puits de potentiel entre les première et deuxième parties 11' 12. Le niveau de la bande de conduction et le niveau de la bande de valence de la couche de dispersion sont respectivement plus et moins énergétiques que les niveaux de la bande correspondante des première et deuxième parties 11, 12.

Ainsi, la couche de dispersion 13 forme avec la première partie 11 une chute de potentiel pour les porteurs de la première zone 10 lorsque ces derniers passent de la première partie 11 à la couche de dispersion 13.

De même dans cette configuration, la couche de dispersion 13 forme à son interface avec la deuxième partie 12 une barrière de potentiel pour les porteurs de la première zone 10 lorsque ces derniers passent de la couche de dispersion 13 à la deuxième partie 12. La couche de dispersion 13 forme ainsi, avec la chute de potentiel formée à son interface avec la première partie 11 et avec la barrière de potentiel formée à son interface avec la deuxième partie 12 un puits de potentiel.

Les porteurs de la première zone 10 lorsqu'ils passent de la première partie 11 à la couche de dispersion 13 perdent, en raison de la chute de potentiel, une partie de leur énergie potentielle qui est convertie en énergie cinétique et se retrouvent partiellement confinés dans la couche de dispersion 13 en raison de la barrière de potentiel. Les porteurs de la première zone 10, avec cette énergie cinétique et en étant partiellement confinés, se dispersent dans les directions comprises dans le plan de la couche de dispersion permettant ainsi l'obtention d'une répartition plus homogène du courant lors de son passage dans la jonction.

La résistivité de la couche 13 est supérieure à celles de la première et de la deuxième partie 11, 12 de la première zone 10.

La concentration en porteurs majoritaires de la couche de dispersion 13 est adaptée pour que cette dernière présente une résistivité plus forte que celle de la première et de la deuxième partie 11, 12.

Une structure 1 selon l'application particulière décrite dans le premier mode de réalisation peut être adaptée selon le deuxième mode de réalisation. Dans une telle adaptation, la couche de dispersion 13 n'est pas réalisée dans le même matériau que celui de la première et de la deuxième partie 11, 12 mais est réalisée en nitrure de gallium-indium $In_xGa_{1-x}N$ avec une proportion relative de 5 % d'indium In. Les autres caractéristiques de la structure 1 restent identiques à celles précédemment décrites.

Une couche de dispersion 13 ainsi formée en nitrure de gallium-indium $In_xGa_{1-x}N$ présente une concentration en porteurs majoritaires inférieure à celle de la première et de la deuxième partie 11, 12 de la première zone 10. En effet, dans le cas d'une première et deuxième partie 11, 12 en nitrure de gallium GaN, l'incorporation d'indium In pour former la couche de dispersion 13 permet de diminuer la concentration en l'élément dopant, généralement le silicium Si, fournissant les porteurs majoritaires.

Un procédé de fabrication d'une structure 1 selon ce deuxième mode de réalisation se différencie d'un procédé de fabrication d'une structure 1 selon le premier mode de réalisation dans la réalisation de l'étape de formation de la couche de dispersion 13.

En effet, pour un procédé de fabrication d'une structure 1 selon le deuxième mode de réalisation, la couche de dispersion 13 étant réalisée dans un matériau possédant une largeur de bande interdite inférieure de celle de la première et de la deuxième partie 11, 12, il est nécessaire de modifier le matériau déposé entre l'étape de formation de la deuxième partie 12 et l'étape de formation de la couche de dispersion 13. On peut noter que pour des matériaux semiconducteurs offrant la possibilité de modifier la largeur de bande interdite par le changement de proportion d'un élément comme c'est le cas par exemple pour les nitrures de gallium-indium $In_xGa_{1-x}N$ et pour les oxydes de zinc-manganèse $Zn_xMg_{1-x}O$, il est possible de former la couche de dispersion 13 en modifiant la proportion d'au moins un des éléments de manière à obtenir la largeur de bande interdite adéquate et de modifier la concentration en éléments dopants. Après formation de la couche de dispersion 13, les conditions de dépôt utilisées pour la formation de la deuxième partie 12 sont rétablies afin de former la première partie 11.

## Troisième mode de réalisation

La figure 5 illustre schématiquement un diagramme de bandes en bandes plates d'une structure 1 selon un troisième mode de réalisation de l'invention. Une structure 1 selon le troisième mode de réalisation se différencie d'une structure 1 selon le deuxième mode de réalisation en ce que la deuxième partie 12 présente une largeur de bande interdite qui est inférieure à celle de la couche de dispersion 13.

Dans ce troisième mode de réalisation la couche formant la deuxième partie 12 est réalisée dans un matériau semiconducteur, préférentiellement à gap direct, qui possède une largeur de bande interdite inférieure à celle de la couche de dispersion 13.

Une telle deuxième partie 12, en présentant une conductivité sensiblement identique à celle de la première partie 11, permet à la couche de dispersion 13 de former avec la deuxième partie une chute de potentiel pour les porteurs majoritaires de la première zone 10 lorsque ces derniers passent de la couche de dispersion 13 à la deuxième partie 12.

Ainsi, pour une structure 1 selon le troisième mode de réalisation, comme pour une structure 1 selon le deuxième mode réalisation, un porteur, en passant de la première partie 11 à la couche de dispersion 13, et donc en passant par la chute de potentiel formée à l'interface entre la première partie 11 et la couche de dispersion 10, voit son énergie potentielle en partie diminuée et convertie en énergie cinétique. Les porteurs peuvent, avec cette énergie cinétique se disperser notamment selon les directions comprises dans le plan de la couche de dispersion 13.

De plus, dans ce mode de réalisation, la couche de dispersion 13 formant une chute de potentiel avec la deuxième partie 12, les porteurs subissent également une perte d'une partie de leur énergie potentielle qui est convertie en énergie cinétique lors de leur passage de la couche de dispersion 13 à la deuxième partie 12. Ainsi, les porteurs peuvent de nouveau, avec cette énergie cinétique, se disperser notamment selon les directions comprises dans le plan de la couche de dispersion 13.

Le troisième mode de réalisation est particulièrement avantageux car les porteurs ne sont soumis à aucune barrière énergétique dans la zone 10. En conséquence les tensions de fonctionnement de la structure sont plus faibles que celles d'une structure selon les modes de réalisation précédemment exposés.

Dans ce troisième mode de réalisation, comme le montre la figure 5, La couche de dispersion 13 est constituée d'un seul matériau semiconducteur. La concentration en porteurs majoritaires de la couche de dispersion 13 est adaptée pour que cette dernière présente une résistivité plus forte que celle de la première et de la deuxième partie 11, 12. De même, la concentration en porteurs majoritaires de la deuxième partie 12 est adaptée pour que la deuxième partie 12 de la première zone 10 présente une résistivité inférieure à celle de la première partie 11 de la première zone 10.

Un tel troisième mode de réalisation peut être adapté à l'application particulière décrite dans le premier mode de réalisation. Dans une telle adaptation, la couche de dispersion 13 est réalisée selon l'adaptation déjà décrite pour le deuxième mode de réalisation tandis que la première partie 11 est réalisée en nitrure de gallium-indium $In_xGa_{1-x}N$ avec la proportion relative en indium In qui est de 10%. Selon cette même adaptation, le type de conductivité et la résistivité de la première partie 11 reste sensiblement les mêmes que celle selon l'adaptation décrite pour le deuxième mode de réalisation.

Une couche de dispersion 13 ainsi formée en nitrure de gallium-indium $In_xGa_{1-x}N$ présente une concentration en porteurs majoritaires inférieure à celle de la première et de la deuxième partie 11, 12 de la première zone 10. En effet, l'incorporation d'indium In pour former la couche de dispersion 13 permet de diminuer la concentration en l'élément dopant, le silicium Si par exemple dans le cas où l'une de la première et la deuxième partie 11, 12 est réalisée en nitrure de gallium GaN, fournissant les porteurs majoritaires.

Un procédé de fabrication d'une structure 1 selon ce troisième mode de réalisation se différencie d'un procédé de fabrication d'une structure 1 selon le deuxième mode de réalisation par la réalisation de l'étape de formation de la deuxième partie 12 de la première zone 10.

En effet, pour un procédé de fabrication d'une structure 1 selon le troisième mode de réalisation, la deuxième partie 12 étant réalisée dans un matériau possédant une largeur de bande interdite inférieure à celle de la première partie 11 et de la couche de dispersion 13, il est nécessaire que le matériau déposé, selon un principe similaire au procédé de fabrication d'une structure 1 selon le deuxième mode de réalisation, soit modifié lors du passage de la deuxième partie 12 à la couche de dispersion 13 et lors du passage de la couche de dispersion 13 à la première partie 11. Ainsi, un procédé de fabrication d'une structure 1 selon ce troisième mode de réalisation se différencie d'un procédé de fabrication d'une structure 1 selon le deuxième mode de réalisation en ce que lors du passage de la couche de dispersion 13 à la première partie 11 les conditions de dépôt ne sont pas rétablies à celles utilisées pour le dépôt de la deuxième partie 12 mais sont adaptées pour déposer un matériau présentant une largeur de bande interdite supérieure à celle de la couche de dispersion 13 et à celle de la deuxième partie 12.

Dans l'ensemble des modes de réalisation décrits dans ce document les structures 1 sont toutes des diodes électroluminescentes d'un même type qui est le type diode verticale à film mince (plus connu sous la dénomination anglaise « Vertical Thin Film Diode » et sous le sigle anglais VTF LED). Néanmoins le principe de l'invention peut être appliqué à un autre type de diode électroluminescente. Ainsi, il est possible, sans que l'on sorte du cadre de l'invention, de prévoir une couche de dispersion dans des diodes électroluminescentes aussi bien du type conventionnel (connu sous sa dénomination anglaise « Conventional Chip Diode » et sous son sigle anglais CC LED), du type puce retournée (connue sous sa dénomination anglaise « Flip Chip » et sous son sigle anglais FC LED) ou encore, par exemple, du type puce retournée à film mince (plus connue sous sa dénomination anglaise « Thin Film Flip Chip » et sous son sigle anglais TFFC LED).

Si dans le deuxième et le troisième mode réalisation décrits ci-dessus, la couche de dispersion 13 forme avec la première partie et avec la deuxième partie de la première zone des hétérojonctions de manière à fournir avec ces dernières une chute ou une barrière de potentiel pour les porteurs majoritaires de la première zone, il est également envisageable, sans que l'on sorte du cadre de l'invention de former un telle chute ou barrière de potentiel avec une homojonction. En effet, dans le cas où la première et la deuxième partie de la première zone, et la couche de dispersion sont réalisées en un même matériau, une concentration en éléments dopants adaptée dans la couche de dispersion 13 permet de former, pour les porteurs majoritaires de la première zone 10 une chute ou une barrière de potentiel.

Quatrième mode de réalisation

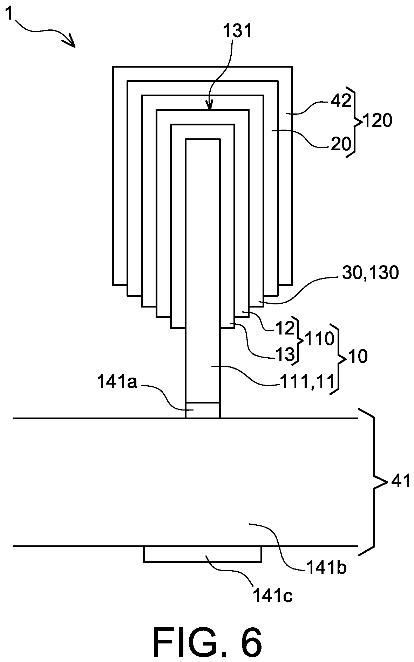

La figure 6 illustre une structure selon un quatrième mode de réalisation. Une telle structure se différencie d'une structure selon le premier mode de réalisation en ce que la structure 1 est un fil semiconducteur présentant une configuration cœur coquille dans laquelle le plan de jonction se présente sensiblement sous la forme d'une enveloppe séparant un cœur de fil 111 longiligne et une coquille 120, dite extérieure, entourant le cœur de fil 111 au niveau de l'une de ses extrémités et sur au moins une partie de sa hauteur.

Dans l'ensemble de ce document, on entend par fils, nanofils ou microfils semiconducteurs des structures semiconductrices présentant trois dimensions et de forme allongée, dont deux sont du même ordre de grandeur comprises entre 5 nm et 2,5 $\mu$m, la troisième dimension étant au moins égale à 2 fois, 5 fois ou préférentiellement 10 fois la plus grande des deux autres dimensions.

Dans ce quatrième mode de réalisation, la structure 1 étant un fil semiconducteur présentant une configuration du type cœur-coquille, l'ensemble des couches, zones et parties de zone que comporte la structure 1, mis à part la première partie de la première zone 10 qui forme le cœur de fil 111, présente une forme sensiblement en coquille. Une telle forme en coquille est, comme illustré sur la figure 6, une forme cylindrique creuse logeant la couche, zone ou partie de zone se trouvant directement en dessous. Avec une telle forme, l'épaisseur d'une couche, zone ou partie de zone s'entend comme la dimension de la couche, zone, ou partie de zone selon une direction perpendiculaire à l'axe longitudinal du cœur de fil 111, cette dimension pouvant être variable en fonction de la position par rapport au positionnement de la mesure le long de la structure.

Ainsi, dans ce quatrième mode de réalisation, la première partie 11 de la première zone 10 forme le corps de fils 111 tandis que la couche de dispersion 13, la deuxième partie 12 de la première zone 10 forment une première coquille intermédiaire 110, la troisième zone 30 une deuxième coquille intermédiaire 130 et la deuxième zone 20 avec le deuxième contact 42 une coquille extérieure 120. Une telle configuration dans laquelle les différentes parties et zones s'entourent successivement peut être définie comme une configuration du type gigogne.

Pour rappel, le terme gigogne s'entend généralement, comme c'est le cas dans ce document, comme signifiant « qui se compose de plusieurs éléments de forme analogue et de taille décroissante pouvant s'emboîter les uns dans les autre ».

Le premier contact électrique 41 comporte :

- un support 141b préférentiellement semiconducteur avec une première et une seconde face,
- une plot de contact 141c métallique disposé sur la première face du support,
- un plot de nucléation 141a en contact avec le support sur sa seconde face, le plot de nucléation 141a faisant interface entre le cœur de fil 111 et le support 141b.

Une telle configuration du premier contact électrique 41 dans ce quatrième mode de réalisation est plus particulièrement adaptée pour l'application particulière dans laquelle la première partie de la première zone est en nitrure de gallium. On peut noter qu'il est également envisageable, ceci sans que l'on sorte du cadre de l'invention, que le cœur de fil 111 et le support 141b soient directement en contact, ou encore qu'il soit prévu une couche tampon, pour former interface entre le plot de nucléation 141a/cœur de fil 111 et le support 141b.

Le cœur de fil 111 s'étend longitudinalement à partir du plot de nucléation 141a dans une direction sensiblement perpendiculaire à la deuxième face du support 141b. Le cœur de fil 111 peut présenter une section selon le plan de la deuxième face du support en forme de disque, carrée, elliptique ou encore polygonale telle qu'hexagonale, voire quelconque. De même, si la section du cœur de fil 111 selon le plan de la deuxième face est préférentiellement sensiblement constante le long du cœur de fil 111, cette dernière section peut également présenter une variation monotone ou autre sans sortir du cadre de l'invention.

Dans l'application particulière, le cœur de fil 111 présente, préférentiellement, une section selon le plan de la deuxième face du support qui est hexagonale.

Dans l'application particulière de l'invention à ce quatrième mode de réalisation, le cœur de fil 111 peut être en nitrure de gallium GaN avec un type de conductivité dans lequel les porteurs majoritaires sont des électrons. La concentration en porteurs majoritaires dans le cœur de fil 111 est adaptée pour présenter une résistivité comprise entre $1.10^{-4}$ et $1.10^{-2}$ $\Omega$.cm et préférentiellement de l'ordre de $1.10^{-3}$ $\Omega$.cm

Le cœur de fil 111 est, au niveau de son extrémité opposée au support 141b et sur au moins une partie de son pourtour, en contact avec la couche de dispersion 13. Ainsi la couche de dispersion 13 entoure le cœur de fil 111 au niveau de son extrémité opposée au support 141b et sur au moins une partie de sa hauteur.

La deuxième partie 12 de la première zone entoure la couche de dispersion 13 sur la face de cette dernière qui est opposée au cœur de fil 111 ceci au niveau de l'extrémité du cœur de fil 111 qui est opposée au support 141b et de manière à recouvrir au moins une partie de la hauteur de la couche de dispersion 13 sur laquelle elle recouvre le cœur de fil 111.

La couche de dispersion 13, la deuxième partie 12 de la première zone 10 forment une première coquille intermédiaire 110 qui entoure le cœur de fil 111 au niveau de son extrémité opposée au support 141b sur au moins une partie de sa hauteur.

Cette même première coquille intermédiaire 110 est, au niveau de l'extrémité du cœur de fil 111 opposée au support 141b, sur au moins une partie de la hauteur de la première coquille 110 sur laquelle elle est en contact avec le cœur de fil 111, en contact avec la troisième zone 30.

La troisième zone 30, formant la deuxième coquille intermédiaire 130, peut présenter une configuration similaire à celle déjà décrite pour le premier mode de réalisation. Ainsi, la troisième zone 30 d'une structure 1 selon ce quatrième mode de réalisation peut comporter un ou plusieurs systèmes de confinement de porteurs, tel qu'un unique puits quantique, des multi-puits quantiques formant ou non un super-réseau.

La troisième zone 30 est elle-même, au niveau de l'extrémité du cœur de fil 111 et au moins sur une partie de l'hauteur sur laquelle elle recouvre la première coquille intermédiaire 110, en contact avec la deuxième zone 20.

La deuxième zone 20 est, au niveau de l'extrémité du cœur de fil 111 opposée au support 141b, sur au moins une partie de la hauteur de la deuxième zone 20 sur laquelle elle est en contact avec le la troisième zone 30, en contact avec le deuxième contact 42.

Le deuxième contact 42 est préférentiellement formé d'un matériau conducteur au moins partiellement transparent à la longueur d'onde à laquelle est destinée à émettre la structure 1, et encore plus préférentiellement totalement transparent à cette même longueur d'onde. Ainsi, selon cette dernière caractéristique, le deuxième contact 42 peut être par exemple un oxyde transparent conducteur, tel que l'oxyde d'indium-étain (plus connu sous son sigle anglais ITO), ou un métal de faible épaisseur préférentiellement inférieure à l'épaisseur de peau de ce même métal.

Le procédé de fabrication d'une structure 1 selon ce quatrième mode de réalisation présente les étapes suivantes de :

- fourniture d'un support semiconducteur 141b,
- formation d'un plot de nucléation 141a,
- formation du plot de contact 141c en contact avec le support semiconducteur 141b sur une face de ce dernier qui est opposée au plot de nucléation, de manière à former le premier contact avec le support semiconducteur 141b et le plot de nucléation 141a le premier contact 41,
- formation du cœur de fil 111 en contact avec le plot de nucléation 141a, de manière à former la première partie 11 de la première zone 10,
- formation de la première coquille 110 en contact avec le cœur de fil 111, en formant en contact avec le cœur de fil 111 la couche de dispersion 13 et la deuxième partie de la première zone 10, ceci de manière à former la première zone 10,
- formation de la deuxième coquille intermédiaire 130 en contact avec la première coquille intermédiaire 110, ceci en formant la troisième zone 30,
- formation de la coquille extérieure 120 en contact avec la deuxième coquille intermédiaire 130, en formant la deuxième zone 20 et le deuxième contact 42.

Bien entendu, de même que pour le procédé de fabrication des modes précédents, l'ordre des étapes n'est donné qu'à titre indicatif et n'est nullement limitatif. Ainsi par exemple, l'étape de formation du plot de contact 141c peut être réalisée postérieurement à l'étape de formation de la coquille extérieure 120 sans que l'on sorte du cadre de l'invention

Selon une autre possibilité de ce quatrième mode de réalisation, non illustrée, le fil semiconducteur peut présenter une configuration cœur-coquille dans laquelle la coquille extérieure 120 entoure le cœur de fil 111 uniquement sur une partie de sa hauteur sans que la coquille extérieure 120 n'entoure l'une des extrémités du cœur de fil 111. Dans cette autre possibilité du quatrième mode de réalisation, chacune des couches, zones et parties de zone que comporte la structure 1, mis à part la première partie de la première zone 10 qui forme le cœur de fil 111, présente une forme sensiblement tubulaire entourant la couche, zone ou partie de zone directement inférieure en direction du cœur de fil sur une partie de la hauteur du cœur de fil, les extrémités du cœur de fil 111 restant libres.

Une structure 1 selon ce quatrième mode de réalisation est particulièrement adaptée pour être intégrée et répliquée dans un composant semiconducteur 200.

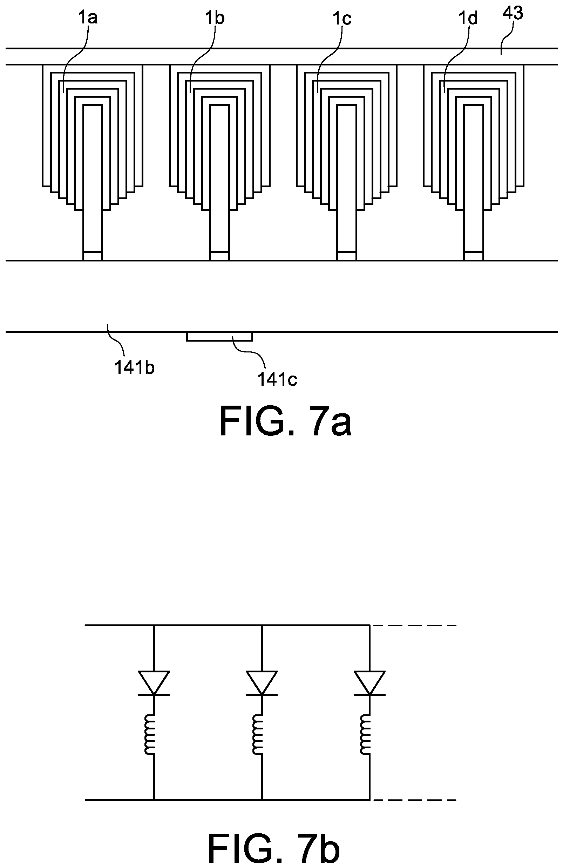

La figure 7a illustre ainsi un tel composant semiconducteur 200 dans lequel quatre structures 1a, 1b, 1c, 1d selon le quatrième mode de réalisation ont été intégrées. Dans un tel composant semiconducteur 200 les fils 1a, 1b, 1c, 1d équipent un support semiconducteur 141b formant avec les plots de nucléation 141a des fils 1a, 1b, 1c, 1d, un premier contact électrique commun.

Les fils 1a, 1b, 1c, 1d sont répartis le long de la surface du support, soit de façon ordonnée, comme c'est le cas sur la figure 7a et selon une possibilité préférée de l'invention, soit de façon aléatoire. Les caractéristiques de chacun des fils 1a, 1b, 1c, 1d équipant un tel composant sont identiques à celles préalablement décrites dans ce quatrième mode de réalisation.

Selon une première possibilité de l'invention, dans un tel composant, le deuxième contact 42 de chacun des fils peut être relié à une électrode commune 43 de manière à ce que les fils 1a, 1b, 1c, 1d soient mis en parallèle. L'électrode commune 43 comprend, comme cela est illustré sur la figure 7a, une couche s'étendant en contact avec l'extrémité des fils 1a, 1b, 1c, 1d qui est opposée au support 141b sensiblement parallèlement à la deuxième face du support 141b. De cette manière l'électrode commune 43 est en contact électrique avec chacun des fils 1a, 1b, 1c, 1d.

L'électrode commune 43 est configurée, par exemple par une constitution de cette dernière dans un matériau au moins partiellement transparent à la ou aux longueurs d'onde à laquelle ou auxquelles sont destinés à émettre les fils 1a, 1b, 1c, 1d, pour autoriser le passage du rayonnement électromagnétique émis par les fils 1a, 1b, 1c, 1d. Un tel matériau au moins partiellement transparent peut être, par exemple un oxyde transparent conducteur (connu sous le sigle OTC) tel que l'oxyde d'indium-étain, ou encore une couche métallique de faible épaisseur adaptée pour laisser passer une part majoritaire du rayonnement émis.

Dans un composant semiconducteur 200 selon cette première possibilité, la couche de dispersion permet, en plus d'améliorer la distribution du courant au niveau de la jonction de chacun des fils 1a, 1b ,1c ,1d, d'améliorer la répartition du courant entre les fils 1a, 1b ,1c ,1d. En effet, la couche de dispersion 13 ajoute, comme le montre le schéma fonctionnel de la figure 7b, une résistance supplémentaire à chacun des fils 1a, 1b, 1c, 1d dont la valeur est directement liée à l'épaisseur et à l'agencement de la couche de dispersion 13. Ainsi, la résistance fournie par la couche de dispersion 13 étant relativement homogène, on obtient une valeur d'impédance relativement homogène des fils 1a, 1b, 1c, 1d et donc un courant bien réparti entre ces mêmes fils 1a, 1b, 1c, 1d.

Une telle première possibilité est particulièrement avantageuse pour fournir un composant semiconducteur avec des structures destinées à fournir un éclairage de forte puissance lumineuse.

On peut noter qu'un procédé de fabrication d'un composant semiconducteur 200 selon cette possibilité comporte les mêmes étapes de fabrication de structure selon ce quatrième mode de réalisation, ces dernières étapes étant réalisées en parrallèle sur toute la surface afin de former une pluralité de structures, à laquelle est ajoutée une étape de fourniture de l'électrode commune 43.

Selon une deuxième possibilité de l'invention, non illustrée, les fils 1a, 1b, 1c, 1d peuvent être connectés indépendamment les uns des autres de manière à pouvoir commander individuellement leur émission. De même que pour la première possibilité décrite ci-dessous, la couche de dispersion 13 permet d'homogénéifier l'impédance des fils 1a, 1b, 1c, 1d et donc l'intensité lumineuse émise par chacun des fils 1a, 1b, 1c, 1d pour une polarisation donnée.

Un composant semiconducteur 200 selon cette deuxième possibilité est particulièrement adapté pour fournir une surface d'affichage, telle qu'un écran.

Bien entendu, si une structure 1 selon ce quatrième mode de réalisation est décrit avec une configuration de la première zone 10 qui est commune avec une structure 1 selon le premier mode de réalisation, la structure 1 selon ce quatrième mode de réalisation peut également, sans que l'on sorte du cadre de l'invention, posséder une configuration de la première zone 10 selon l'un quelconque parmi le deuxième et le troisième mode de réalisation.

Les différentes structures décrites ci-dessus au travers de ces quatre modes de réalisation ne sont données qu'à titre d'exemple des possibilités de l'invention et ne sont pas limitatives. En effet, l'invention englobe l'ensemble des structures semiconductrices émettrices de lumière comme définies dans les revendications attenantes, présentant dans l'une des deux zones formant une jonction émettrice une couche de dispersion adaptée pour disperser les porteurs dans les directions comprises dans le plan de la couche de dispersion, ceci en formant, par exemple, un accroissement localisé de la résistivité et/ou une chute de potentiel dans ladite zone à l'encontre d'au moins un type de porteurs, préférentiellement du type de porteurs majoritaires de ladite zone.

## Revendications

1. Structure (1) semiconductrice adaptée pour émettre un rayonnement électromagnétique, ladite structure (1) comportant :

   - une première et une deuxième zone (10, 20) présentant respectivement un premier et un second type de conductivité opposé l'un par rapport à l'autre, lesdites première et deuxième zones (10, 20) étant reliées l'une à l'autre pour former une jonction semiconductrice, la dite jonction s'étendant le long d'un plan (31), dit plan de jonction,

dans laquelle la première zone (10) comporte au moins une première et une deuxième partie (11, 12), telles que la deuxième partie (12) est la partie par laquelle la première zone (10) est reliée à la deuxième zone (20),

la première et la deuxième partie (11, 12) étant séparées l'une de l'autre par une couche (13) intermédiaire, dite de dispersion, s'étendant sensiblement parallèlement au plan de jonction le long d'une majeure partie de la jonction, ladite couche de dispersion (13) étant adaptée pour provoquer une dispersion des porteurs dans les directions comprises dans le plan de la couche de dispersion (13),

dans laquelle la couche de dispersion (13) présente sur toute son épaisseur une résistivité plus forte que celle de la première partie (11) de la première zone (10),

dans laquelle la couche de dispersion (13) est constituée d'un seul matériau semiconducteur,

dans laquelle la première partie (11) de la première zone (10) est une couche sensiblement parallèle au plan de jonction, la première partie (11) de la première zone (10) présentant une résistivité $\rho_1$ et une épaisseur $d_1$, la couche de dispersion (13) présentant une résistivité $\rho_d$ et une épaisseur $d_d$ et la jonction présentant dans le plan de jonction (31) une dimension maximale 2L,

la structure (1) **étant caractérisée en ce que** les épaisseurs et les résistivités respectives de la première partie (11) de la première zone (10) et de la couche de dispersion (13) respectent l'inégalité suivante:

$$\frac{\rho_1}{\rho_d} < 100 \frac{d_1 \times d_d}{L^2}.$$

2. Structure (1) selon la revendication 1, dans laquelle la couche de dispersion (13) est adaptée pour former avec la première partie (11) une chute de potentiel pour les porteurs majoritaires de la première zone (10) lorsque ces derniers passent de la première partie (11) à la couche de dispersion (13).

3. Structure (1) selon la revendication 1 ou 2, dans laquelle la couche de dispersion (13) est adaptée pour former avec la deuxième partie (12) une chute de potentiel pour les porteurs majoritaires de la première zone (10) lorsque ces derniers passent de la couche de dispersion (13) à la deuxième partie (12).

4. Structure (1) selon la revendication 1 ou 2, dans laquelle la couche de dispersion (13) est adaptée pour former avec la deuxième partie (12) une barrière de potentiel pour les porteurs majoritaires de la première zone (10) lorsque ces derniers passent de la couche de dispersion (13) à la deuxième partie (12).

5. Structure (1) selon les revendications 2 et 4 dans laquelle la couche de dispersion (13) forme un puits de potentiel, pour les porteurs majoritaires de la première zone (10), entre la première et la deuxième partie (11, 12) de la première zone.

6. Structure (1) selon l'une quelconque des revendications 2 à 5 dans laquelle la première zone (10) est formée d'au moins trois éléments chimiques dont la proportion en au moins un desdits éléments permet de varier la largeur de bande interdite d'un matériau semiconducteur formé desdits éléments, la couche de dispersion présentant une proportion moyenne en au moins un des éléments différents de celle d'au moins la première partie (11) de manière à ce que la couche de dispersion (13) présente une largeur de bande interdite inférieure à celle de la première partie (11).

7. Structure (1) selon l'une quelconque des revendications 1 à 5, dans laquelle la première et la deuxième partie (11, 12) de la première zone (10) et la couche de dispersion (13) sont réalisées en un même matériau.

8. Structure (1) selon l'une quelconque des revendications 1 à 7, dans laquelle la structure (1) est une structure du type planaire, c'est-à-dire que le plan de jonction se présente sous une forme sensiblement plane.

9. Structure (1) selon l'une quelconque des revendications 1 à 7, dans lequel la structure est un fil semiconducteur présentant une configuration du type cœur-coquille, le plan de jonction se présentant sous la forme sensiblement d'une enveloppe séparant un cœur de fil (111) longiligne et une coquille extérieure (120) entourant le cœur de fil (111) au moins sur une partie de sa hauteur.

10. Structure (1) selon la revendication 9, dans laquelle le cœur de fil (111) forme la première partie (11) de la première zone (10) et dans laquelle, la couche de dispersion (13), la deuxième partie (12) de la première zone (10), la troisième zone (30) et la deuxième zone (20) présentent chacune une forme de coquille dans une configuration du type gigogne.

11. Composant semiconducteur comportant une pluralité de fils semiconducteurs chacun adapté pour émettre un rayonnement électromagnétique, **caractérisé en ce qu'**au moins deux fils semiconducteurs (1a, 1b, 1c, 1d) sont des fils selon la revendication 9 ou 10.

12. Procédé de fabrication d'une structure (1) semiconductrice selon l'une quelconque des précédentes revendications comportant les étapes consistant à :

- former la première partie (11) de la première zone (10),
- former la couche de dispersion (13) en contact sur l'une de ses deux faces avec la première partie (11), ladite couche de dispersion étant constituée d'un seul matériau semiconducteur et présentant une résistivité supérieure à celle de la première partie (11) de la première zone (10),
- former la deuxième partie (12) de la première zone (10) en contact avec la couche de dispersion (13) sur la face de la couche de dispersion (13) qui est opposée à la première partie (11), ladite deuxième partie (12) de la première zone (10) présentant une résistivité inférieure à celle de la couche dispersion (13),
- former la deuxième zone (20) de la structure (1), la deuxième zone (20) de la structure (1) étant reliée à la première zone (10),
dans lequel la première partie (11) est une couche sensiblement parallèle au plan de jonction, la première partie (11) de la première zone (10) présentant une résistivité $\rho_1$ et une épaisseur $d_1$, la couche de dispersion (13) présentant une résistivité $\rho_d$ et une épaisseur $d_d$ et la jonction présentant dans le plan de jonction (31) une dimension maximale 2L, les épaisseurs et les résistivités respectives de la première partie (11) de la première zone (10) et de la couche de dispersion (13) respectant l'inégalité suivante :

$$\frac{\rho_1}{\rho_d} < 100 \frac{d_1 \times d_d}{L^2}.$$

13. Procédé selon la revendication précédente dans lequel la première zone (10) est une multicouche comportant une première et une deuxième couche formant respectivement la première et la deuxième partie (11,12) de la zone (10), les étapes de formation de la première et de la deuxième partie (11, 12) étant chacune une étape de dépôt d'un matériau semiconducteur afin de former une couche dudit matériau.

14. Procédé selon la revendication précédente dans laquelle, les étapes de formation des première et deuxième parties (11, 12) et de la couche de dispersion (13) sont réalisées en une seule étape consistant à déposer un matériau semiconducteur comportant au moins un type d'éléments dopants adaptés pour fournir des porteurs correspondant au premier type de conductivité, la concentration en l'au moins un type d'éléments dopants étant variée pendant le dépôt de manière à former la couche de dispersion (13).

15. Procédé selon la revendication 14, dans lequel, les première et deuxième parties (11, 12) de la première zone (10) et la couche de dispersion (13) sont formées de matériaux semiconducteurs présentant pour au moins la première partie (11) et la couche de dispersion (13) une largeur de bande interdite différente, la formation des première et deuxième parties (11, 12) et de la couche de dispersion (13) étant réalisée en une seule étape consistant à déposer des éléments chimiques, formant un matériau semiconducteur, dont la composition est variée pendant le dépôt de manière à former successivement la deuxième partie (12), la couche de dispersion (13) et la première partie (11).

16. Procédé selon la revendication 14 ou l'une quelconque des revendication 13 à 15 en combinaison avec la revendication 12, dans lequel l'étape de formation de la première partie de la première zone est une étape de fourniture d'un cœur de fil (111), les étapes de formation de la couche de dispersion, de la deuxième partie et de la deuxième zone étant des étapes de formation de couches présentant chacune une forme sensiblement en coquille.

17. Procédé de fabrication d'un composant semiconducteur (200) comportant la mise en œuvre en parallèle de chacune des étapes de fabrication d'une structure selon l'une quelconque des revendications 13 à 16 de manière à former une pluralité de structures (1a, 1b, 1c, 1d).

**Patentansprüche**

1. Halbleiterstruktur (1), die dazu ausgelegt ist, eine elektromagnetische Strahlung zu emittieren, wobei die Struktur (1) enthält:

- einen ersten und einen zweiten Bereich (10, 20), die einen ersten bzw. einen zweiten Leitfähigkeitstyp aufweisen, die einander entgegengesetzt sind, wobei der erste und der zweite Bereich (10, 20) miteinander verbunden sind, um einen Halbleiterübergang zu bilden, wobei sich der Übergang entlang einer Ebene (31), Übergangsebene genannt, erstreckt, wobei der erste Bereich (10) zumindest einen ersten und einen zweiten Abschnitt (11, 12) enthält, derart, der zweite Abschnitt (12) derjenige Abschnitt ist, durch den der erste Bereich (10) mit dem zweiten Bereich (20) verbunden ist, wobei der erste und der zweite Abschnitt (11, 12) durch eine Zwischenschicht (13), Streuschicht genannt, voneinander getrennt sind, die sich im Wesentlichen parallel zur Übergangsebene entlang eines Großteils des Übergangs erstreckt, wobei die Streuschicht (13) dazu ausgelegt ist, eine Streuung der Ladungsträger in den in der Ebene der Streuschicht (13) enthaltenen Richtungen hervorzurufen, wobei die Streuschicht (13) über ihre gesamte Dicke einen spezifischen Widerstand aufweist, der höher als der des ersten Abschnitts (11) des ersten Bereichs (10) ist, wobei die Streuschicht (13) aus einem einzigen Halbleitermaterial besteht, wobei der erste Abschnitt (11) des ersten Bereichs (10) eine im Wesentlichen parallel zur Übergangsebene verlaufende Schicht ist, wobei der erste Abschnitt (11) des ersten Bereichs (10) einen spezifischen Widerstand $\rho_1$ und eine Dicke $d_1$ aufweist, wobei die Streuschicht (13) einen spezifischen Widerstand $\rho_d$ und eine Dicke $d_d$ aufweist und der in der Übergangsebene (31) vorhandene Übergang eine maximale Abmessung 2L aufweist, wobei die Struktur (1) **dadurch gekennzeichnet ist, dass**

die Dicken und die jeweiligen spezifischen Widerstände des ersten Abschnitts (11) des ersten Bereichs (10) und der Streuschicht (13) die nachstehende Ungleichung erfüllen:

$$\frac{\rho_1}{\rho_d} < 100 \, \frac{d_1 \times d_d}{L^2}$$

2. Struktur (1) nach Anspruch 1, wobei die Streuschicht (13) dazu ausgelegt ist, mit dem ersten Abschnitt (11) ein Potentialgefälle für die Majoritätsträger des ersten Bereichs (10) zu bilden, wenn letztere vom ersten Abschnitt (11) in die Streuschicht (13) übergehen.

3. Struktur (1) nach Anspruch 1 oder 2, wobei die Streuschicht (13) dazu ausgelegt ist, mit dem zweiten Abschnitt (12) ein Potentialgefälle für die Majoritätsträger des ersten Bereichs (10) zu bilden, wenn letztere von der Streuschicht (13) in den zweiten Abschnitt (12) übergehen.

4. Struktur (1) nach Anspruch 1 oder 2, wobei die Streuschicht (13) dazu ausgelegt ist, mit dem zweiten Abschnitt (12) eine Potentialbarriere für die Majoritätsträger des ersten Bereichs (10) zu bilden, wenn letztere von der Streuschicht (13) in den zweiten Abschnitt (12) übergehen.

5. Struktur (1) nach den Ansprüchen 2 und 4, wobei die Streuschicht (13) zwischen dem ersten und dem zweiten Abschnitt (11, 12) des ersten Bereichs einen Potentialtopf für die Majoritätsträger des ersten Bereichs (10) bildet.

**6.** Struktur (1) nach einem der Ansprüche 2 bis 5, wobei der erste Bereich (10) aus zumindest drei chemischen Elementen gebildet ist, deren Anteil an mindestens einem der Elemente gestattet, die Bandlücke eines aus diesen Elementen gebildeten Halbleitermaterials zu variieren, wobei die Streuschicht einen mittleren Anteil an zumindest einem der Elemente aufweist, der sich von dem des zumindest einen ersten Abschnitts (11) unterscheidet, so dass die Streuschicht (13) eine kleinere Bandlücke als die des ersten Abschnitts (11) aufweist.

**7.** Struktur (1) nach einem der Ansprüche 1 bis 5, wobei der erste und der zweite Abschnitt (11, 12) des ersten Bereichs (10) und die Streuschicht (13) aus einem gleichen Material hergestellt sind.

**8.** Struktur (1) nach einem der Ansprüche 1 bis 7, wobei die Struktur (1) eine Struktur vom planaren Typ ist, d.h. die Übergangsebene im Wesentlichen plan ist.

**9.** Struktur (1) nach einem der Ansprüche 1 bis 7, wobei die Struktur ein Halbleiterdraht mit einer Kern-Schale-Konfiguration ist, wobei die Übergangsebene im Wesentlichen in Form einer Hülle vorliegt, die einen länglichen Drahtkern (111) und eine äußere Schale (120) trennt, die den Drahtkern (111) zumindest über einen Teil seiner Höhe umgibt.

**10.** Struktur (1) nach Anspruch 9, wobei der Drahtkern (111) den ersten Abschnitt (11) des ersten Bereichs (10) bildet und wobei die Streuschicht (13), der zweite Abschnitt (12) des ersten Bereichs (10), der dritte Bereich (30) und der zweite Bereich (20) jeweils eine Schalenform in einer übereinander gestülpten Konfiguration aufweisen.

**11.** Halbleiterbauteil mit einer Mehrzahl von Haltleiterdrähten, die jeweils dazu ausgelegt sind, eine elektromagnetische Strahlung zu emittieren, **dadurch gekennzeichnet, dass** zumindest zwei Halbleiterdrähte (1a, 1b, 1c, 1d) Drähte nach Anspruch 9 oder 10 sind.

**12.** Verfahren zum Herstellen einer Halbleiterstruktur (1) nach einem der vorangehenden Ansprüche, umfassend die Schritte:

- Ausbilden des ersten Abschnitts (11) des ersten Bereichs (10),
- Ausbilden der Streuschicht (13), die auf einer ihrer beiden Seiten mit dem ersten Abschnitt (11) in Kontakt steht, wobei die Streuschicht aus einem einzigen Halbleitermaterial besteht und einen höheren spezifischen Widerstand als der erste Abschnitt (11) des ersten Bereichs (10) aufweist,

- Ausbilden des zweiten Abschnitts (12) des ersten Bereichs (10), der auf derjenigen Seite der Streuschicht (13), die dem ersten Abschnitt (11) entgegengesetzt ist, mit der Streuschicht (13) in Kontakt steht, wobei der zweite Abschnitt (12) des ersten Bereichs (10) einen geringeren spezifischen Widerstand als die Streuschicht (13) aufweist,
- Ausbilden des zweiten Bereichs (20) der Struktur (1), wobei der zweite Bereich (20) der Struktur (1) mit dem ersten Bereich (10) verbunden ist, wobei der erste zweite Abschnitt (11) eine im Wesentlichen parallel zur Übergangsebene verlaufende Schicht ist, wobei der erste Abschnitt (11) des ersten Bereichs (10) einen spezifischen Widerstand $\rho_1$ und eine Dicke $d_1$ aufweist, wobei die Streuschicht (13) einen spezifischen Widerstand $\rho_d$ und eine Dicke $d_d$ aufweist und der in der Übergangsebene (31) vorhandene Übergang eine maximale Abmessung 2L aufweist, wobei die Dicken und die jeweiligen spezifischen Widerstände des ersten Abschnitts (11) des ersten Bereichs (10) und der Streuschicht (13) die nachstehende Ungleichung erfüllen:

$$\frac{\rho_1}{\rho_d} < 100\,\frac{d_1 \times d_d}{L^2}$$

**13.** Verfahren nach dem vorangehenden Anspruch, wobei der erste Bereich (10) mehrschichtig aufgebaut ist und eine erste und eine zweite Schicht enthält, die den ersten bzw. den zweiten Abschnitt (11, 12) des Bereichs (10) bilden, wobei die Schritte des Ausbildens des ersten und des zweiten Abschnitts (11, 12) jeweils ein Schritt des Abscheidens von einem Halbleitermaterial sind, um eine Schicht aus diesem Material zu bilden.

**14.** Verfahren nach dem vorangehenden Anspruch, wobei die Schritte des Ausbildens des ersten und des zweiten Abschnitts (11, 12) und der Streuschicht (13) in einem einzigen Schritt erfolgen, der darin besteht, ein Halbleitermaterial mit zumindest einem Typ von Dotierungselementen abzuscheiden, die dazu ausgelegt sind, Ladungsträger bereitzustellen, die dem ersten Leitfähigkeitstyp entsprechen, wobei die Konzentration an dem zumindest einen Typ von Dotierungselementen während des Abscheidens variiert wird, so dass die Streuschicht (13) entsteht.

**15.** Verfahren nach Anspruch 14, wobei der erste und der zweite Abschnitt (11, 12) des ersten Bereichs (10) und die Streuschicht (13) aus Halbleitermaterialien gebildet werden, die zumindest für den ersten Abschnitt (11) und die Streuschicht (13) eine unterschiedliche Bandlücke aufweisen, wobei das Ausbilden des ersten und des zweiten Abschnitts (11, 12) und der Streuschicht (13) in einem einzigen Schritt erfolgt, der darin besteht, chemische Elemente abzuscheiden, die ein Halbleitermaterial bilden, dessen Zusammensetzung während des Abschneidens variiert wird, so dass nacheinander der zweite Abschnitt (12), die Streuschicht (13) und der erste Abschnitt (11) entstehen.

16. Verfahren nach Anspruch 14 oder einem der Ansprüche 13 bis 15 in Kombination mit Anspruch 12, wobei der Schritt des Ausbildens des ersten Abschnitts des ersten Bereichs ein Schritt des Bereitstellens eines Drahtkerns (111) ist, wobei die Schritte des Ausbildens der Streuschicht, des zweiten Abschnitts und des zweiten Bereichs Schritte des Ausbilden von Schichten sind, die jeweils im Wesentlichen schalenförmig sind.

17. Verfahren zum Herstellen eines Halbleiterbauteils (200), umfassend das parallel erfolgende Durchführen eines jeden der Schritte zum Herstellen einer Struktur nach einem der Ansprüche 13 bis 16 derart, dass eine Mehrzahl von Strukturen (1a, 1b, 1c, 1d) entsteht.

**Claims**

1. A semiconducting structure (1) adapted to emit electromagnetic radiation, said structure (1) comprising:

    - a first and a second zone (10, 20) with a first and a second type of conductivity respectively opposite to each other, said first and second zones (10, 20) being connected to each other to form a semiconducting junction, said junction extending along a plane (31), called the junction plane,
    Wherein the first zone (10) comprises at least a first and a second part (11, 12), such that the second part (12) is the part through which the first zone (10) is connected to the second zone (20),
    the first part and the second part (11, 12) being separated from each other by an intermediate layer (13), called the spreading layer, extending approximately parallel to the junction plane along a major part of the junction, said spreading layer (13) being adapted to cause spreading of carriers along directions included in the plane of the spreading layer (13),
    wherein the spreading layer (13) has a higher resistivity than the first part (12) of the first zone (10) over its entire thickness,
    wherein the spreading layer (13) is formed of a single semiconducting material,
    wherein the first part (11) of the first zone (10) is a layer approximately parallel to the junction plane, the first part (11) of the first zone (10) having a resistivity $\rho_1$ and a thickness $d_1$, the spreading layer (13) having a resistivity $\rho_d$ and a thickness $d_d$ and the junction having a maximum dimension 2L in the junction plane (31), the structure **being characterized in that** the thicknesses and resistivities of the first part (11) of the first zone (10) and the spreading layer (13) respectively respectes the following relation:

$$\frac{\rho_1}{\rho_d} < 100 \frac{d_1 \times d_d}{L^2}.$$

2. The structure (1) according to claim 1, wherein the spreading layer (13) is adapted to work with the first part (11) to form a potential drop for majority carriers of the first zone (10) when these carriers pass from the first part (11) to the spreading layer (13).

3. The structure (1) according to claim 1 or 2, wherein the spreading layer (13) is adapted to form a potential drop with the second part (12) for majority carriers of the first zone (10) when these carriers pass from the spreading layer (13) to the second part (12).

4. The structure (1) according to any one of claims 1 or 2, wherein the spreading layer (13) is adapted so that, with the second part (12), it forms a potential barrier for majority carriers of the first zone (10) when the majority carriers pass from the spreading layer (13) to the second part (12).

5. The structure (1) according to claims 2 and 4, wherein the spreading layer (13) forms a potential well, for majority carriers of the first zone (10), between the first part and the second part (11, 12) of the first zone.

6. The structure (1) according to any one of claims 2 to 5, wherein the first zone (10) is formed of at least three chemical elements of which the proportion of at least one of said elements can vary the energy band gap of a semiconducting material formed from said elements, the spreading layer having an average proportion of at least one of the elements different from the average proportion of at least the first part (11) such that the energy band gap of the spreading layer (13) is less than the energy band gap of the first part (11).

7. The structure (1) according to any one of claims 1 to 5, wherein the first part and the second part (11, 12) of the first zone (10) and the spreading layer (13) are made from the same material.

8. The structure (1) according to any one of claims 1 to 7, wherein the structure (1) is a planar type structure, in other words the shape of the junction plane is approximately plane.

9. The structure (1) according to any one of claims 1 to 7, wherein the structure is a semiconducting wire with a core-shell type configuration, the junction plane being approximately in the form of an envelope separating an elongated wire core (111) and an outer shell (120) surrounding the wire core (111) over at least part of its height.

10. The structure (1) according to claim 9, wherein the wire core (111) forms the first part (11) of the first zone (10) and in which each of the spreading layer (13), the second part (12) of the first zone (10), the third zone (30) and the second zone (20) is in the form of a shell in a nested type configuration.

11. A semiconducting component comprising a plurality of semiconducting wires each adapted to emit electromagnetic radiation, **characterised in that** at least two semiconducting wires (1a, 1b, 1c, 1d) are semiconducting wires according to claim 9 or 10.

12. A method of manufacturing a semiconducting structure (1) according to any one of the previous claims comprising the following steps:

- form the first part (11) of the first zone (10),
- form the spreading layer (13) in contact with the first part on one of its two faces (11), said spreading layer being composed of a single semiconducting material and having a resistivity higher than the resistivity of the first part (11) of the first zone (10),
- form the second part (12) of the first zone (10) in contact with the spreading layer (13) on the face of the spreading layer (13) opposite the first part (11), said second part (12) of the first zone (10) having a resistivity lower than the resistivity of the spreading layer (13),
- form the second zone (20) of the structure (1), the second zone (20) of the structure (1) being connected to the first zone (10).

13. The method according to the previous claim, wherein the first zone (10) is a multi-layer with a first and a second layer forming the first and the second parts (11, 12) of the zone (10) respectively, each of the steps to form the first and the second parts (11, 12) being a step in which a semiconducting material is deposited in order to form a layer of said material.

14. The method according to the previous claim, wherein the steps in which the first and second parts (11, 12) and the spreading layer (13) are formed are done in a single step consisting of depositing a semiconducting material comprising at least one type of doping elements adapted to produce carriers corresponding to the first type of conductivity, the concentration of at least one of the doping elements being varied during the deposit so as to form the spreading layer (13).

15. The method according to claim 15, wherein the first part and the second part (11, 12) of the first zone (10) and the spreading layer (13) are formed from semiconducting materials with a different energy band gap for at least the first part (11) and the spreading layer (13), the steps to form the first and second parts (11, 12) and the spreading layer (13) taking place in a single step consisting of depositing chemical elements, forming a semiconducting material, the composition of which is varied during the deposition so as to form the second part (12), the spreading layer (13) and the first part (11) in sequence.

16. The method according to claim 13 or any one of claims 14 to 16 combined with claim 13, wherein the step in which the first part of the first zone is formed is a step to produce a wire core (111), the steps to form the spreading layer, the second part and the second zone being steps to form layers each of which has an approximately

17. A method for manufacturing a semiconducting component (200) comprising the parallel use of each of the manufacturing steps of a structure according to any one of claims 14 to 17 so as to form a plurality of structures (1a, 1b, 1c, 1d).

FIG. 1

FIG. 2

FIG. 3

FIG. 4

FIG. 5

FIG. 6

FIG. 7a

FIG. 7b

**EP 2 948 988 B1**

## RÉFÉRENCES CITÉES DANS LA DESCRIPTION

### Documents brevets cités dans la description

- US 20020104997 A1